# EUROPEAN PATENT APPLICATION

(11) **EP 3 136 441 A1**
(43) Date of publication of application: **01.03.2017**
(21) Application number: 16184612.6
(22) Date of filing: 17.08.2016
(51) Int. Cl.: H01L 29/40, H01L 29/423, H01L 21/336, H01L 29/78, H01L 29/06

(54) **SEMICONDUCTOR DEVICE AND METHOD OF MANUFACTURING SEMICONDUCTOR DEVICE**

(30) Priority: 27.08.2015 JP 2015167933
(71) Applicant: Renesas Electronics Corporation, Tokyo 135-0061 (JP)
(72) Inventor: MORI, Takahiro, Hitachinaka-shi, Ibaraki 312-8504 (JP)
(74) Representative: Betten & Resch

(57) **Abstract**

To provide an LDMOS semiconductor device having improved properties. A semiconductor device having a source region and a drain region, a channel formation region, a drain insulating region between the channel formation region and the drain region, and a gate electrode is provided. The drain insulating region has a slit exposing therefrom an active region and this slit is placed on the side of the channel formation region with respect to the center of the drain insulating region. This active region is formed as an n type semiconductor region. Such a configuration enables relaxation of an electric field of the drain insulating region on the side of the channel formation region (on the side of the source region). The generation number of hot carriers (hot electrons, hot holes) can therefore be reduced. As a result, a semiconductor device having improved HCI-related properties can be obtained.

## Description

### CROSS-REFERENCE TO RELATED APPLICATIONS

The disclosure of Japanese Patent Application No. 2015-167933 filed on August 27, 2015 including the specification, drawings, and abstract is incorporated herein by reference in its entirety.

### BACKGROUND

The present invention relates to a semiconductor device and a method of manufacturing a semiconductor device, which can be suited for use, for example, in a semiconductor device having an LDMOS transistor.

An LDMOSFET (Laterally Diffused Metal-Oxide-Semiconductor Field Effect Transistor, LDMOS transistor, laterally diffused MOSFET, or LDMISFET, which may hereinafter be called "LDMOS" simply) uses a RESURF (REduced surface Field) MOS transistor as a common structure. The structure under investigation is that obtained by forming a thick oxide film on the surface of a semiconductor substrate and placing a drain-side edge of a gate electrode on the oxide film and thereby relaxing field intensity below the drain-side edge of the gate electrode. For example, Patent Documents 1 to 3 disclose a semiconductor device having a thick oxide film at a drain-side edge.

### [Patent Documents]

[Patent Document 1] Japanese Unexamined Patent Application Publication No. 2009-130021
[Patent Document 2] Japanese Unexamined Patent Application Publication No. 2014-107302
[Patent Document 3] WO/2015/079511

### SUMMARY

It has been revealed that the LDMOS investigated by the present inventors has room for further improvement in its configuration.

In the LDMOS, for example, influence of hot carriers generated at the time of HCI becomes a problem.

The semiconductor device described in Patent Document 1 (Japanese Unexamined Patent Application Publication No. 2009-130021), however, has increased ON resistance because a P⁺ region is formed as the current path of the LDMOS. In addition, in such an LDMOS configuration, electric field relaxation does not occur at a junction portion between P⁺ region and n⁻ region. Trapping of hot electrons in the LOCOS end portion cannot therefore be relaxed at the time of HCI.

In the semiconductor device described in Patent Document 2 (Japanese Unexamined Patent Application Publication No. 2014-107302), a gate oxide film can be protected from hot electrons generated at the time of HCI by dividing a gate electrode, but the electric field at the STI portion which is a place causing hot electrons cannot be relaxed.

The semiconductor device described in Patent Document 3 (WO2015/079511) has a diffusion layer region on the drain side so that the electric field in a channel-side region of a drain insulating film cannot be relaxed and an effect for improving HCI cannot be produced. In addition, the diffusion layer region has no gate poly on the drain side thereof so that electric field relaxation at the time of breakdown cannot be expected.

There is accordingly a demand for the investigation of the configuration of an LDMOS capable of having improved HCI-related properties.

Another problem and novel features will be apparent from the description herein and accompanied drawings.

Of the embodiments disclosed herein, a typical one will next be outlined briefly.

A semiconductor device shown in one embodiment disclosed herein has a source region and a drain region, a channel formation region, an insulating region between the channel region and the drain region, and a gate electrode.

The insulating region has a slit exposing therefrom an active region and this slit is on the side of the channel formation region with respect to the center of the insulating region.

The semiconductor device disclosed herein and shown below in the typical embodiment can have improved properties.

By the method of manufacturing a semiconductor device disclosed herein and shown below in the typical embodiment, a semiconductor device having improved properties can be manufactured.

### BRIEF DESCRIPTION OF THE DRAWINGS

FIG. 1 is a cross-sectional view showing a configuration of a semiconductor device of First Embodiment;
FIG. 2 is a schematic plan view showing the configuration of the semiconductor device of First Embodiment;
FIG. 3 is a cross-sectional view showing another configuration of the semiconductor device of First Embodiment;
FIG. 4 is a plan view showing the another configuration of the semiconductor device of First Embodiment;
FIG. 5 is a plan view showing the another configuration of the semiconductor device of First Embodiment;
FIG. 6 is a cross-sectional view showing a manufacturing step of the semiconductor device of First Embodiment;
FIG. 7 is a cross-sectional view showing a manufacturing step of the semiconductor device of First Embodiment;
FIG. 8 is a plan view showing a manufacturing step of the semiconductor device of First Embodiment;
FIG. 9 is a cross-sectional view showing a manufacturing step of the semiconductor device of First Embodiment;
FIG. 10 is a plan view showing a manufacturing step of the semiconductor device of First Embodiment;
FIG. 11 is a cross-sectional view showing a manufacturing step of the semiconductor device of First Embodiment;
FIG. 12 is a cross-sectional view showing a manufacturing step of the semiconductor device of First Embodiment;
FIG. 13 is a plan view showing a manufacturing step of the semiconductor device of First Embodiment;
FIG. 14 is a cross-sectional view showing a manufacturing step of the semiconductor device of First Embodiment;
FIG. 15 is a cross-sectional view showing a manufacturing step of the semiconductor device of First Embodiment;
FIG. 16 is a cross-sectional view showing the configuration of a semiconductor device of Comparative Example of First Embodiment;
FIG. 17 is a graph showing an IG-VGS waveform of the semiconductor device of Comparative Example;
FIG. 18A and 18B are each a graph showing an IG-VGS waveform of the semiconductor device of First Embodiment;
FIG. 19 is an enlarged view of the graph of Comparative Example;
FIG. 20 is a graph showing the relationship between a gate current and a distance S in the semiconductor device of First Embodiment;
FIG. 21 shows a potential distribution and an impact ionization position of the semiconductor device of Comparative Example;
FIG. 22 shows a potential distribution and an impact ionization position of the semiconductor device of First Embodiment;
FIG. 23 shows a potential distribution and an electron current density of the semiconductor device of Comparative Example;
FIG. 24 shows a potential distribution and an electron current density of the semiconductor device of First Embodiment;
FIG. 25 is a cross-sectional view showing the configuration of a semiconductor device of Application Example 1 of Second Embodiment;
FIG. 26 is a cross-sectional view showing the configuration of a semiconductor device of Application Example 2 of Second Embodiment;
FIGS. 27A and 27B are each a graph showing the relationship between a breakdown voltage and an n type semiconductor region;
FIG. 28 shows a potential distribution and an impact ionization position of the semiconductor device of First Embodiment;
FIG. 29 shows a potential distribution and an impact ionization position of the semiconductor device of Application Example 1 of Second Embodiment;
FIG. 30 shows a potential distribution and an impact ionization position of the semiconductor device of Application Example 2 of Second Embodiment;
FIGS. 31A and 31B are each a plan view showing the configuration of a semiconductor device of Application Example 1 of Third Embodiment;
FIG. 32 is a plan view showing the configuration of the semiconductor device of Application Example 1 of Third Embodiment;
FIG. 33 is a plan view showing the configuration of a semiconductor device of Application Example 2 of Third Embodiment;
FIG. 34 is a plan view showing the configuration of the semiconductor device of Application Example 2 of Third Embodiment;
FIG. 35 is a plan view showing the configuration of a semiconductor device of Application Example 3 of Third Embodiment;
FIG. 36 is a plan view showing the configuration of the semiconductor device of Application Example 3 of Third Embodiment;
FIG. 37 is a plan view showing the configuration of a semiconductor device of Application Example 4 of Third Embodiment;
FIG. 38 is a plan view showing the configuration of the semiconductor device of Application Example 4 of Third Embodiment;
FIG. 39 is a plan view for describing a semiconductor device of Application Example 5 of Third Embodiment;
FIG. 40 is a plan view showing the configuration of the semiconductor device of Application Example 5 of Third Embodiment;
FIG. 41 is a cross-sectional view showing the configuration of a semiconductor device of Fourth Embodiment;
FIG. 42 is a graph showing the relationship between a gate current and a distance S of the semiconductor device of Fourth Embodiment;
FIG. 43 shows a potential distribution and an impact ionization position of the semiconductor device of Fourth Embodiment; and
FIG. 44 shows a potential distribution and an impact ionization position of the semiconductor device of Comparative Example of Fourth Embodiment.

### DETAILED DESCRIPTION

In the following embodiments, a description will be made after divided into a plurality of sections or embodiments if necessary for the sake of convenience. These sections or embodiments are not independent from each other unless otherwise particularly specified, but one of them may be a modification example, an application example, a detailed description, a complementary description, or the like of a part or whole of the other one. In the following embodiments, when a reference is made to the number (including the number, value, amount, range, or the like) of a component, the number is not limited to a specific number but may be more or less than the specific number, unless otherwise particularly specified or principally apparent that the number is limited to the specific number.

Further, in the following embodiments, the constituent component (including component step or the like) is not always essential unless otherwise particularly specified or principally apparent that it is essential. Similarly, in the following embodiments, when a reference is made to the shape, positional relationship, or the like of the constituent component, that substantially approximate or analogous to its shape or the like is also embraced unless otherwise particularly specified or principally apparent that it is not. This also applies to the above-described number (including the number, value, amount, range, or the like).

Embodiments of the invention will hereinafter be described in detail based on some drawings. In all the drawings for describing the embodiments, members having the same function will be identified by the same or like sign and overlapping descriptions will be omitted. When a plurality of similar members (sites) is present, they are sometimes indicated by a generic sign, to which a reference numeral or the like for showing an individual or specific site may be added. In the following embodiments, a description on the same or similar portion is not repeated in principle unless otherwise particularly necessary.

Even from cross-sectional views used in the following embodiments, hatching may be omitted to facilitate viewing of them. Even plan views, on the other hand, may be hatched to facilitate viewing of them.

In the cross-sectional and plan views, the dimension of each site does not always correspond to that of an actual device and a specific site may be enlarged relatively to facilitate understanding of the drawings. Even in a plan view and a cross-sectional view which are made to correspond to each other, the same site may be indicated by respectively different dimensions.

### (First Embodiment)

A semiconductor device of the present embodiment will hereinafter be described specifically referring to some drawings.

### [Description on structure]

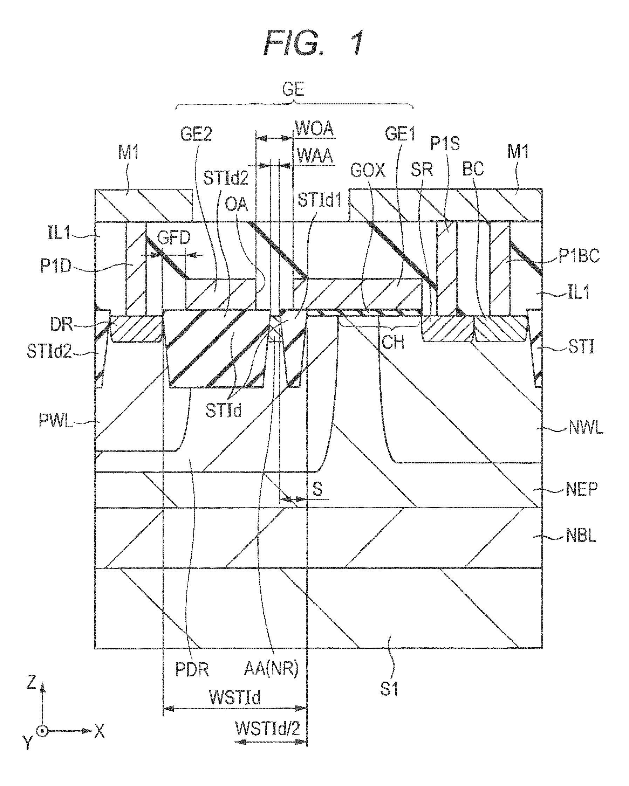

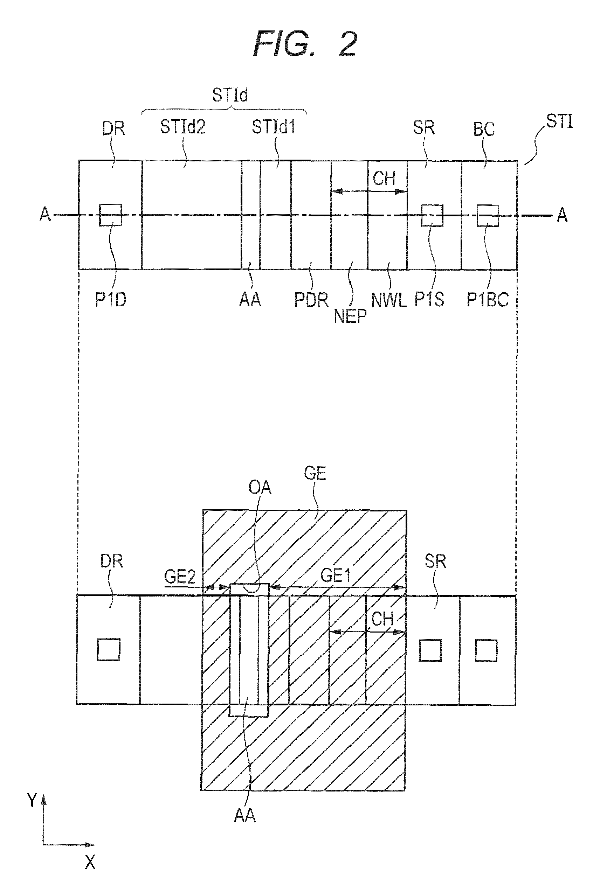

FIG. 1 is a cross-sectional view showing the configuration of the semiconductor device of the present embodiment; and FIG. 2 is a schematic plan view showing the configuration of the semiconductor device of the present embodiment. FIG. 1 corresponds to, for example, a cross-sectional view taken along the line A-A of FIG. 2. FIG. 2 shows, on the upper side thereof, mainly a planar layout of configuration members below the surface of an n⁻ type epitaxial layer NEP, while it shows, on the lower side thereof, a planar layout including, in addition to the configuration members shown on the upper side, a gate electrode GE.

The semiconductor device shown in FIGS. 1 and 2 has a p channel type LDMOS transistor. The LDMOS transistor may also be called "lateral power MOSFET".

The semiconductor device of the present embodiment is on a semiconductor substrate S1 having, on a support board thereof, an n⁻ type epitaxial layer (semiconductor layer) NEP. The n- type epitaxial layer (semiconductor layer) NEP has therebelow an n type buried region (n type semiconductor region) NBL. The n type buried region NBL is a region having an impurity concentration higher than that of the n⁻ type epitaxial layer NEP. The semiconductor device may be formed directly on a substrate (semiconductor layer) made of a semiconductor.

The semiconductor device shown in FIG. 1 has a gate electrode GE (gate electrode portions GE1 and GE2) formed over the semiconductor substrate S1 (the n⁻ type epitaxial layer NEP) via a gate insulating film GOX, and a source region SR and a drain region DR formed on both sides (right and left directions of the sheet in FIGS. 1 and 2) of the gate electrode GE (gate electrode portions GE1 and GE2).

The n type semiconductor regions (NEP and NWL) between the source region (p type semiconductor region, p type impurity region, or p type diffusion region) SR and the drain region (p type semiconductor region, p type impurity region, or p type diffusion region) DR become a channel formation region CH. By providing a p type drift region PDR and a drain insulating region (field drain region) STId between the channel formation region CH and the drain region DR, the electric field at the end portion of the gate electrode GE on the side of the drain region DR can be relaxed (field plate effect). This makes it possible to provide an LDMOS having an increased breakdown voltage.

In the present embodiment, the drain insulating region STId has a slit exposing therefrom an active region AA. In other words, the drain insulating region STId has therein a slit-shaped active region AA. In other words, further, the drain insulating region STId has a first insulating portion STId1 and a second insulating portion STId2 and it has an active region AA between these portions. A portion of the drain insulating region STId on the side of the channel formation region CH (on the side of the source region SR) with respect to the slit-shaped active region AA is called "first insulating portion STId1", while a portion of the drain insulating region STId on the side of the drain region DR with respect to the slit-shaped active region AA is called "second insulating portion STId2".

The active region AA is on the side of the channel formation region CH (on the side of the source region SR) with respect to the center of the drain insulating region STId. In other words, it lies between a position half of an X-direction width WSTId of the drain insulating region STId and the end portion of the drain insulating region STId on the side of the channel formation region (on the side of the source region SR). The X-direction is a channel length direction (gate length direction) and the Y direction is a channel width direction (gate width direction). The width or length described herein is based on the width or length on the surface of the semiconductor substrate S1 (n⁻ type epitaxial layer NEP), respectively insofar as it does not cause any particular trouble.

The active region AA has an n type impurity introduced therein. In other words, the active region AA has, in an upper portion thereof, an n type semiconductor region (impurity region, NR).

The gate electrode GE extends from above the channel formation region CH to over the drain insulating region STId. More specifically, it extends from above the channel formation region CH to over the second insulating portion STId2, passing over the first insulating portion STId1. The slit-shaped active region AA, however, has thereon no gate electrode GE and the slit-shaped active region AA has thereon an opening portion OA. A portion of the gate electrode GE on the side of the channel formation region CH (on the side of the source region SR) with respect to the slit-shaped active region AA is designated as a gate electrode portion GE1 and a portion of the gate electrode GE on the side of the drain region DR with respect to the slit-shaped active region AA is designated as a gate electrode portion GE2.

The X-direction width WOA of the opening portion OA is greater than the X-direction width WAA of the slit-shaped active region AA. Of the first insulating portion STIdl and the second insulating portion STId2 included in the drain insulating region STId, the first insulating portion STId1 has thereon the end portion of the gate electrode portion GE1 on the side of the drain region DR and the second insulating portion STId2 has thereon the gate electrode portion GE2.

Thus, in the present embodiment, since the drain insulating region STId has a slit exposing therefrom the active region AA and this active region AA is formed as an n type semiconductor region, the electric field of the drain insulating region STId on the side of the channel formation region (on the side of the source region SR) can be relaxed. As a result, the generation number of hot carriers (hot electrons or hot holes) can be reduced and HCI-related properties can be improved. The term "HCI" (Hot Carrier Injection) is a phenomenon in which carriers (electrons or holes) of a channel acquire large energy due to field acceleration in a high electric field region, overcome the potential barrier, and are injected and trapped in a gate insulating film. In a p channel type LDMOS as described in the present embodiment, injection of hot carriers is likely to occur also at the channel-side lower end portion of the drain insulating region STId. HCI causes breakdown of the gate insulating film and deteriorates the properties of MISFET such as threshold voltage (Vth) and transfer conductance (gm). The present embodiment, however, succeeds in improvement in HCI-related properties as described above.

In the gate electrode GE, the slit-shaped active region AA has thereon the opening portion OA so that this leads to improvement in breakdown voltage.

The configuration of the semiconductor device of the present embodiment will hereinafter be described in further detail.

The source region SR is in the n well region (n type semiconductor region) NWL. The n well region NWL has an impurity concentration higher than that of the n⁻ type epitaxial layer NEP. The n well region NWL, the n⁻ type epitaxial layer NEP, and the gate electrode GE overlap with one another to form a channel formation region CH. The drain region DR is in a p well region (p type semiconductor region) PWL. This p well region PWL has an impurity concentration lower than that of the drain region DR. The p well region PWL is in a p type drift region (p type semiconductor region) PDR. This p type drift region PDR has an impurity concentration lower than that of the p well region PWL. The p type drift region PDR and the p well region PWL have therein the drain insulating region STId. The drain insulating region STId has, as described above, the first insulating portion STId1 and the second insulating portion STId2. They have therebetween the active region AA.

The semiconductor regions (NWL, PDR, PWL, SR, DR, and BC) are formed in a region (active region) surrounded by an insulating region STI. The insulating region STI and the drain insulating region STId are each made of an insulating film which has filled a trench in the semiconductor substrate S1 (n⁻ type epitaxial layer NEP).

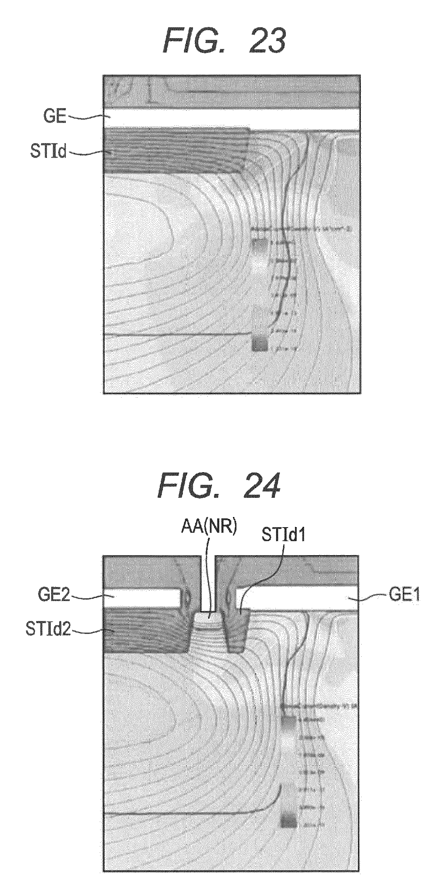

The n well region NWL has therein an n⁺ type body contact region (back gate region) BC which is placed so as to be contiguous to the source region SR. Thus, the source region SR and the n⁺ type body contact region BC have the same potential. Further, the n type semiconductor region (NR) of the active region AA has the same potential as that of the source region SR and the n⁺ type body contact region BC. The n type semiconductor region (NR) of the active region AA may have, for example, a floating potential. Setting the potential of the n type semiconductor region (NR) of the active region AA at the same as that of the source region SR and the n⁺ type body contact region BC (electrical coupling) is effective for partial extraction of an electron current by the n type semiconductor region (NR), that is, effective for extraction of hot electrons generated at the time of HCI which will be described later (refer to FIG. 23). This effect also contributes to improvement in HCI-related properties.

The source region SR and the n⁺ type body contact region BC have thereon a source plug PIS and the drain region DR has thereon a drain plug P1D. Although not shown in the cross-section of FIG. 1, the gate electrode GE has thereon a gate plug. These plugs P1 (source plug PIS, drain plug P1D, and gate plug) are in an interlayer insulating film IL1.

The gate electrode GE extends from above the channel formation region CH to above the drain insulating region STId via the gate insulating film GOX. As described above, however, the slit-shaped active region AA has no gate electrode GE thereon so that the gate electrode GE has an opening portion OA placed on the active region AA. For example, the gate electrode GE has a shape (ring, doughnut, or frame) continuously surrounding the periphery of the opening portion OA (refer to FIG. 2). Such placement of the gate electrode GE so as to surround the slit-shaped active region AA therewith is effective for improvement in breakdown voltage.

FIG. 1 shows configuration members, that is, a pair of the source region SR and the drain region DR and the gate electrode GE, but these members may be arranged repeatedly.

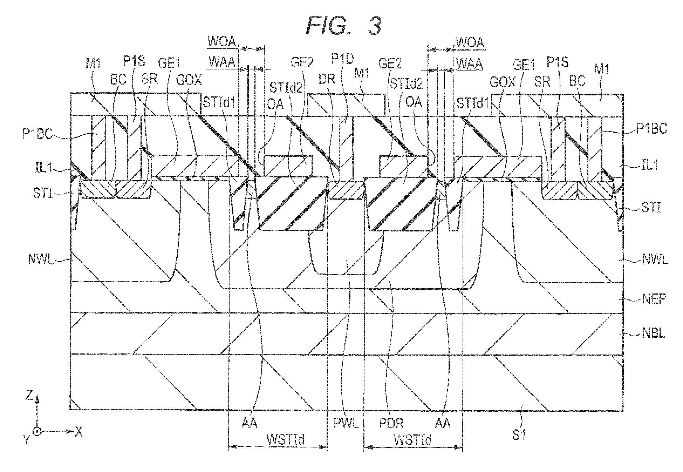

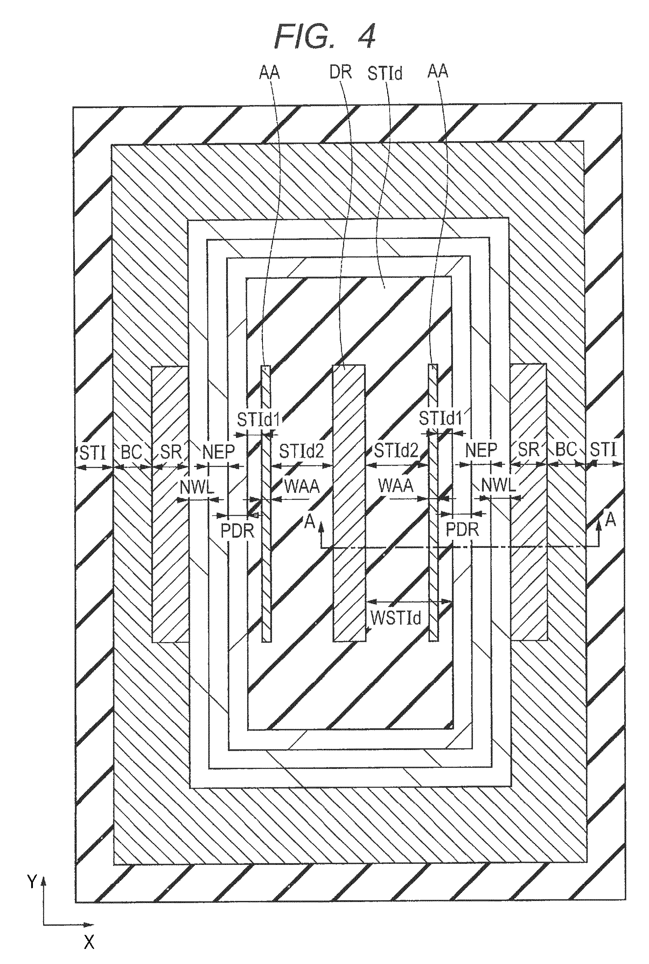

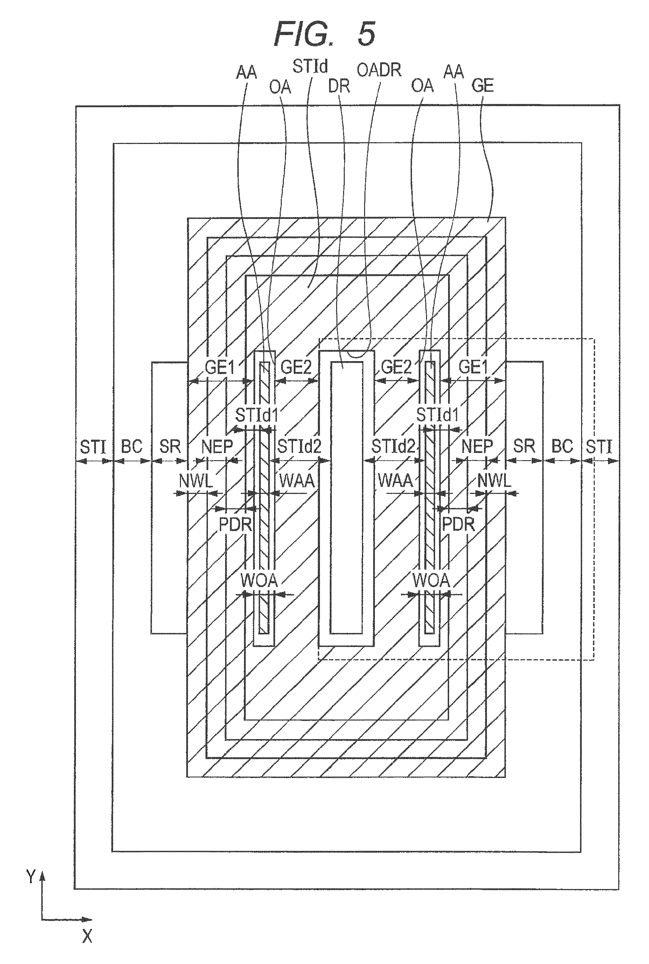

FIGS. 3 to 5 are each a cross-sectional view or a plan view showing another configuration of the semiconductor device of the present embodiment. FIGS. 3 to 5 show a semiconductor device having a source region SR, a drain region DR, and a gate electrode GE, in which the source region and the gate electrode are placed symmetrically with respect to the drain region DR. FIG. 3 corresponds to, for example, the cross-section taken along the line A-A and extension thereof in FIG. 4. FIG. 4 mainly shows a planar layout of the configuration members below the surface of the n⁻ type epitaxial layer NEP and FIG. 5 shows a planar layout including the gate electrode GE in addition to the configuration members shown in FIG. 4.

In the semiconductor device shown in FIG. 3, the configuration members shown in FIG. 1 are placed symmetrically with respect to the drain region DR so that portions corresponding to those of FIG. 1 are identified by the same sign and an overlapping description is omitted. FIGS. 4 and 5 are planar layout examples of the configuration members shown in FIG. 3. As shown in FIG. 4, a substantially rectangularly enclosed body contact region BC has, outside thereof, an insulating region STI. The substantially rectangularly enclosed body contact region BC has, inside thereof, the source region SR. The source region SR has, inside thereof, an exposed surface of the rectangularly enclosed n well region NWL. This rectangularly enclosed n well region NWL has, inside thereof, an exposed surface of the rectangularly enclosed n⁻ type epitaxial layer NEP. The rectangularly enclosed n-type epitaxial layer NEP has, inside the exposed surface thereof, an exposed surface of a rectangularly enclosed p type drift region PDR. The rectangularly enclosed p type drift region PDR has, inside thereof, a rectangular drain insulating region STId. The rectangular drain insulating region STId has therein the drain region DR and two active regions AA. The drain region DR has a rectangular shape extending in the Y direction and it is present at the center of the rectangular drain insulating region STId. This drain region DR has, on both sides thereof, the active regions AA, with a predetermined distance therebetween. These two active regions AA have a rectangular shape with a long side in the Y direction.

Thus, the configuration members extending in the Y direction are placed symmetrically with respect to the drain region DR and some of the configuration members are each coupled and extend also in the direction X. For example, as shown in FIG. 5, the gate electrode GE is placed between the source region SR and the drain region DR. In other words, the gate electrode GE having a substantially rectangular shape is placed inside the rectangularly enclosed source region SR and has, on the drain region DR at the center portion thereof, an opening portion OADR. Further, the gate electrode GE has an opening portion OA on both sides of the drain region DR (opening portion OADR), with a predetermined distance therebetween. The opening portion OA is provided on the active region AA and has a planar shape a size larger than the planar shape of the active region AA.

As shown in FIGS. 4 and 5, the configuration members shown in FIG. 1 are placed symmetrically with respect to the drain region DR. Some of the configuration members extending in the Y direction each have an enclosed planar shape by being coupled in the X direction. The cross-section shown in FIG. 1 corresponds to, for example, that taken along the line A-A of FIG. 4 and the schematic plan view of FIG. 2 corresponds to, for example, a portion of the region surrounded by the broken line of FIG. 5. A further description on the planar layouts shown in FIGS. 4 and 5 is omitted because the configuration of them will become clear by the manufacturing steps described later.

### [Description on manufacturing method]

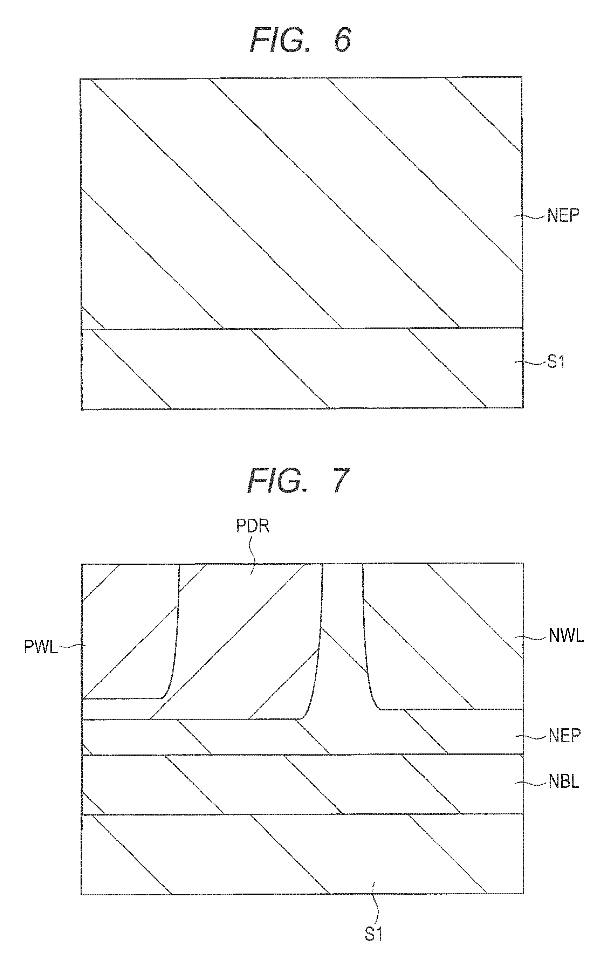

Next, a method of manufacturing the semiconductor device of the present embodiment will be described and the configuration of the semiconductor device will be made clearer referring to FIGS. 6 to 15. FIGS. 6 to 15 are each a cross-sectional view or plan view showing a manufacturing step of the semiconductor device of the present embodiment.

A semiconductor substrate S1 having an n⁻ type epitaxial layer NEP and shown in FIG. 6 is provided. The semiconductor substrate S1 is obtained by using, for example, a single crystal silicon substrate as a support substrate and causing epitaxial growth of, for example, an n⁻ type silicon film on the support substrate. In such a manner, the semiconductor substrate S1 having an n⁻ type epitaxial layer NEP can be formed.

Next, as shown in FIG. 7, an n type buried region (n type semiconductor region) NBL is formed. It is formed, for example, by the ion implantation of an n type impurity into the semiconductor substrate S1 (n⁻ type epitaxial layer NEP) while using, as a mask, a photoresist film (not shown) in which the formation region of the n type buried region NBL has been opened.

Next, a p type drift region PDR and an n well region NWL are formed. For example, with a photoresist film (not shown) in which the formation region of the p type drift region PDR has been opened as a mask, a p type impurity is ion-implanted into the semiconductor substrate S1 (n⁻ type epitaxial layer NEP) to form the p type drift region PDR (p type semiconductor region) PDR. Next, the photoresist film (not shown) is removed by ashing or the like treatment. Then, with a photoresist film (not shown) in which the formation region of the n well region NWL has been opened as a mask, an n type impurity is ion-implanted into the semiconductor substrate S1 (n⁻ type epitaxial layer NEP) to form the n well region (n type semiconductor region) NWL. Then, the photoresist film (not shown) is removed by ashing or the like treatment. A p well region PWL is formed in the p type drift region PDR. For example, with a photoresist film (not shown) in which the formation region of the P well region PWL has been opened as a mask, a p type impurity is ion-implanted into the semiconductor substrate S1 (n- type epitaxial layer NEP) to form the p well region PWL (p type semiconductor region). The photoresist film (not shown) is then removed by ashing or the like treatment.

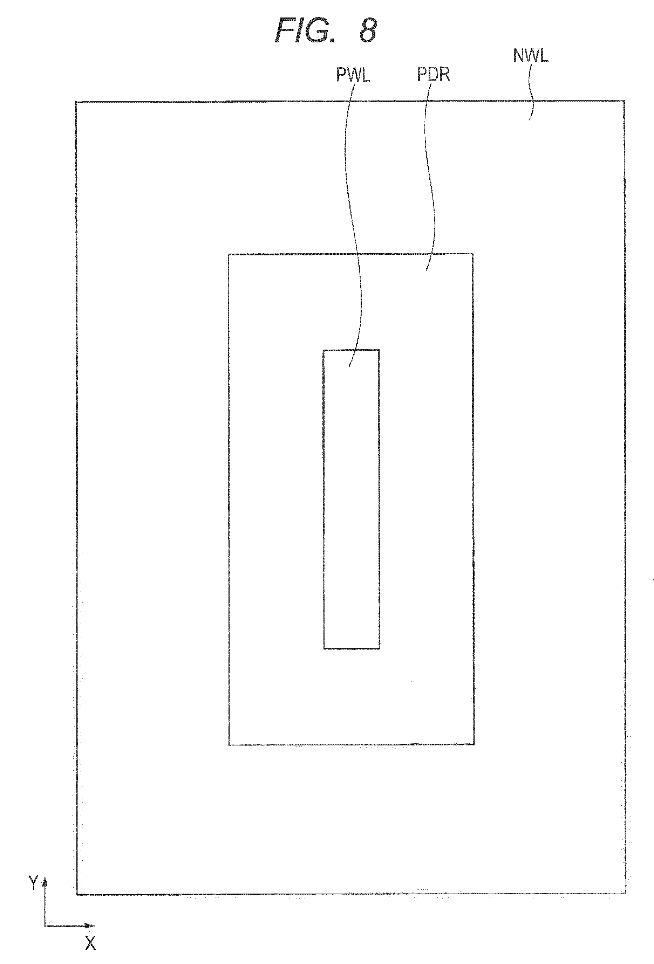

As shown in FIG. 8, the n well region NWL, the p type drift region PDR, and the P well region PWL each have a substantially rectangular planar shape. The p type drift region PDR is formed inside the n well region NWL and the p well region PWL is formed inside the P type drift region PDR.

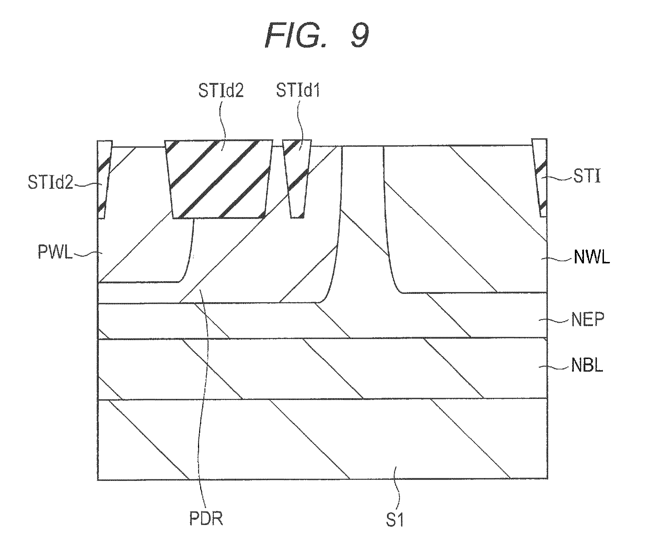

Then, as shown in FIG. 9, an insulating region STI and a drain insulating region STId are formed. The insulating region STI and the drain insulating region STId can be formed using STI (shallow trench isolation). Alternatively, the insulating region STI and the drain insulating region STId may be formed using LOCOS (local oxidation of silicon).

For example, a trench is formed in the semiconductor substrate S1 (n⁻ type epitaxial layer NEP) by photolithography and etching.

Next, a silicon oxide film thick enough to fill the trench therewith is deposited on the semiconductor substrate S1 (n⁻ type epitaxial layer NEP) by CVD (chemical vapor deposition) or the like. The silicon oxide film outside the trench is then removed by chemical mechanical polishing (CMP) or etch back. This makes it possible to fill the trench with the silicon oxide film.

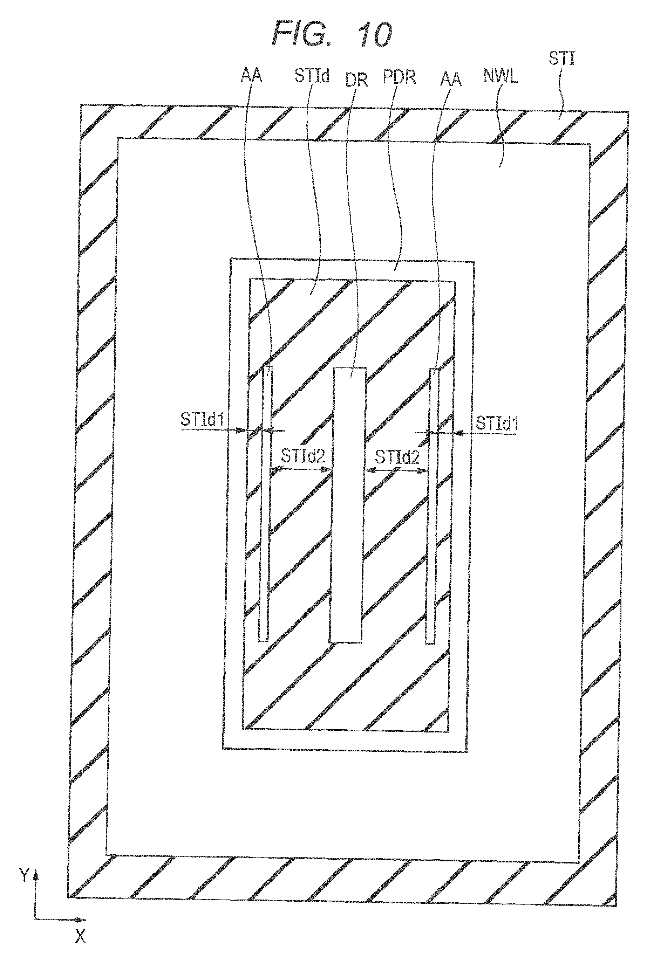

In this step, as shown in FIG. 10, the insulating region STI is formed, for example, outside the n well region NWL. This insulating region STI is formed for electrical isolation between elements (p channel type LDMOS transistors). The drain insulating region STId is formed inside the p type drift region PDR and it has a rectangular outer shape. As described above, however, the drain insulating region STId has therein slit-shaped active regions AA. In addition, the drain insulating region STId has therein an active region (DR) which is a drain-region formation region. The drain insulating region STId has therein the active region (DR) which is a drain-region formation region and also has, on both sides thereof, the active region AA with a predetermined distance therebetween. The active region (DR) which is a drain-region formation region and the two active regions AA each have a rectangular shape with a long side in the Y direction.

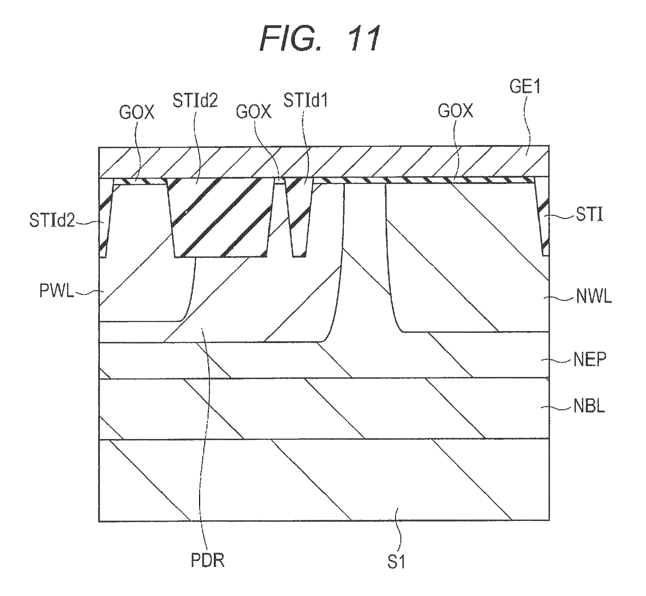

Next, as shown in FIG. 11, conductive films which will be a gate insulating film GOX and a gate electrode GE are formed.

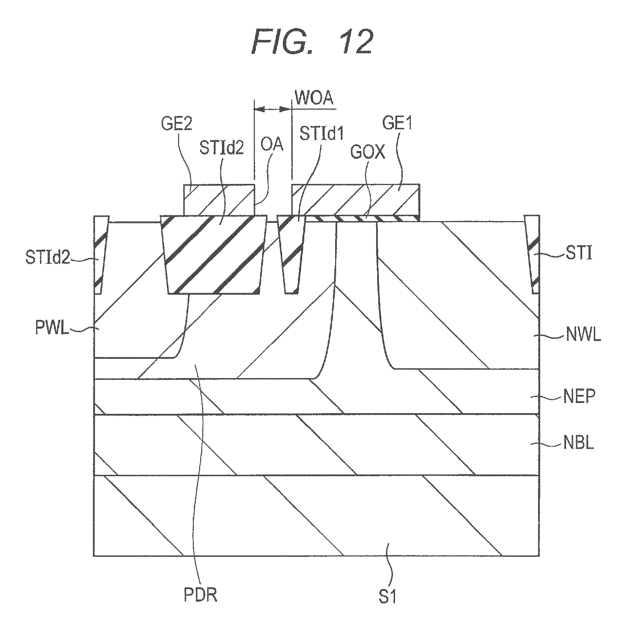

For example, a gate insulating film GOX made of a silicon oxide film or the like is formed on the surface of the n⁻ type epitaxial layer NEP, for example, by thermal treatment (thermal oxidation treatment) of the semiconductor substrate S1. As the gate insulating film GOX, a film formed by CVD may be used instead of the thermal oxide film. Not only an oxide film but also a nitride film or a high dielectric constant film (High-k film) may be used. Next, a polycrystalline silicon film (gate electrode layer) is deposited as a conductive film by CVD or the like on the gate insulating film GOX. The film thus formed is then patterned using photolithography and dry etching. Described specifically, as shown in FIG. 12, a photoresist film (not shown) is formed on the polycrystalline silicon film (gate electrode layer), followed by exposure and development by photolithography to remove a photoresist film in a region other than a formation region of the gate electrode GE. Next, with the photoresist film as a mask, the polycrystalline silicon film (gate electrode layer) is dry etched to form a gate electrode GE. During this etching, the gate insulating film GOX lying below the polycrystalline silicon film is also etched. The photoresist film is then removed by ashing or the like treatment.

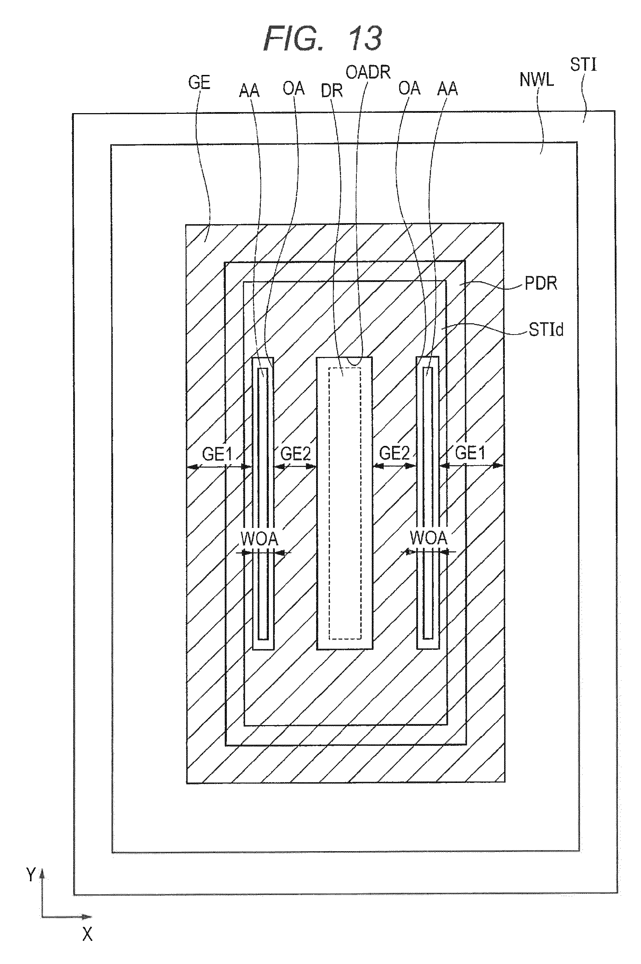

The gate electrode GE of the present embodiment extends from above the n well region NWL to above the drain insulating region STId while going over the p type drift region PDR. The gate electrode GE of the present embodiment, however, has an opening portion (slit) OA with a width WOA on the active region AA (FIG. 13). This gate electrode GE has a shape continuously surrounding the periphery of the opening portion OA. The gate electrode GE described herein has also an opening portion OADR on the active region (DR) which is a drain-region formation region (FIG. 13).

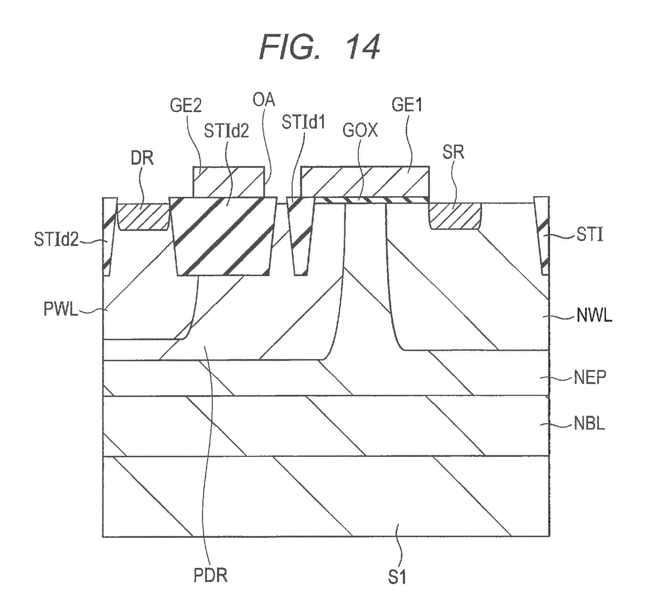

Next, as shown in FIG. 14, a source region SR and a drain region DR are formed. For example, a p type impurity is ion-implanted into a predetermined region with a photoresist film (not shown) having a predetermined shape as an ion implantation preventing mask. In this step, a p type impurity is ion-implanted into the p well region PWL on one side (on the left side in the drawing) of the gate electrode GE, while a p type impurity is ion-implanted into the n well region NWL on the other side (on the right side in the drawing) of the gate electrode GE.

Thus, as shown in FIG. 14, a p⁺ type drain region DR is formed in the surface of a portion of the p well region PWL and a p⁺ type source region SR in the surface of a portion of the n well region NWL. The p⁺ type source region SR is formed in self alignment with the gate electrode GE.

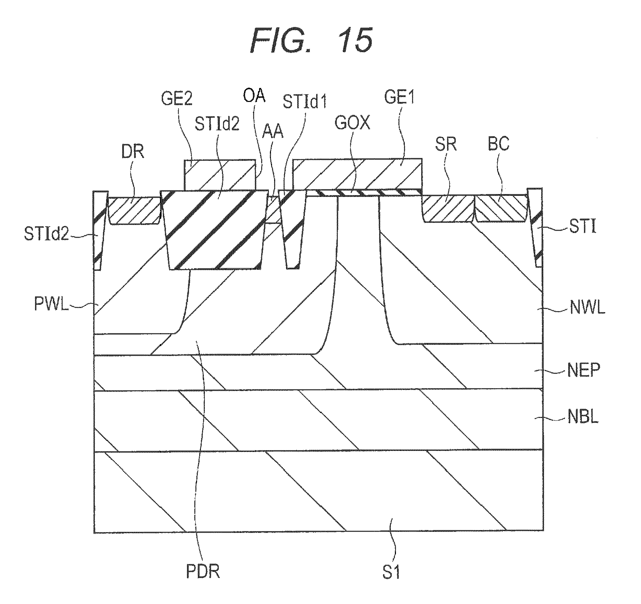

Further, as shown in FIG. 15, with a photoresist mask (not shown) having a predetermined shape as an ion implantation preventing mask, an n type impurity is ion-implanted. By this ion implantation, an n⁺ type body contact region BC and an n type semiconductor region (NR) are formed in the n well region NWL and the active region AA, respectively. In such a manner, the n⁺ type body contact region BC and the n type semiconductor region (NR) in the active region AA may be formed by the same ion implantation step. This enables simplification of manufacturing steps. The n⁺ type body contact region BC and the p⁺ type source region SR are placed adjacent to each other and configure a pn junction.

Next, a silicon oxide film or the like as an interlayer insulating film IL1 is formed using CVD or the like on the semiconductor substrate S1 (n⁻ type epitaxial layer NEP). The surface of the film is then planarized using CMP or the like if necessary.

Next, the interlayer insulating film IL1 is dry etched using, as an etching mask, a photoresist film (not shown) having a predetermined shape to form a contact hole (through-hole) in the interlayer insulating film IL1.

Then, the contact hole is filled with a conductive film to form a plug (contact, contact portion, coupling portion, coupling conductor portion, or coupling plug) P1.

For example, after formation of a barrier film such as titanium nitride film on the interlayer insulating film IL1 including that inside the contact hole, a tungsten film thick enough to fill the contact hole therewith is deposited on the barrier film and then, an unnecessary portion of the tungsten film and the barrier film on the interlayer insulating film IL1 is removed by CMP or etchback. Thus, plugs P1 (P1S, P1D, and P1BC) can be formed.

More specifically, of the plugs P1, a plug formed in the source region SR is indicated as a source plug (source contact portion) P1S, a plug formed in the drain region DR is indicated as a drain plug (drain contact portion) P1D, and a plug formed in the n⁺ type body contact region BC is indicated as a body contact plug (body contact portion) P1BC.

Thus, in the present embodiment, since the drain insulating region STId has a slit from which the active region AA is exposed and this active region AA is formed as an n type semiconductor region, an electric field of the drain insulating region STId on the side of the channel formation region (on the side of the source region SR) can be relaxed. As a result, the generation number of hot carriers (hot electrons, hot holes) can be reduced, resulting in improvement in HCI-related properties.

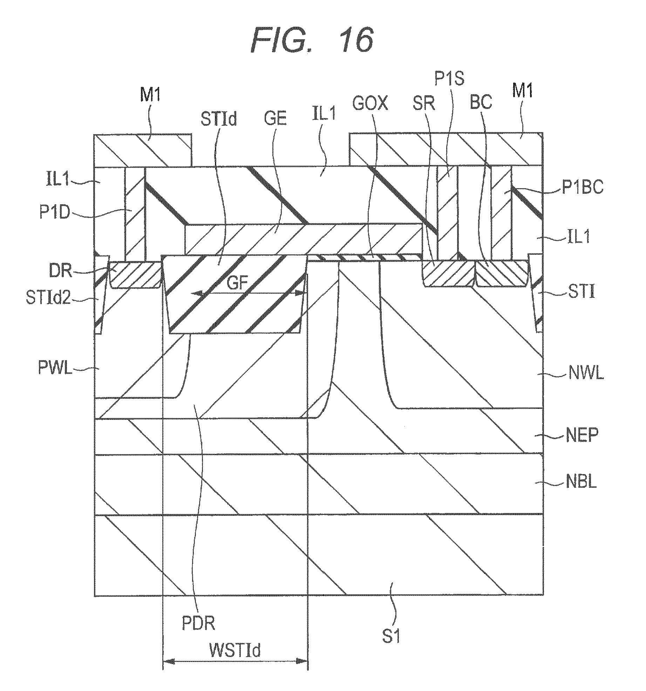

FIG. 16 is a cross-sectional view showing the configuration of a semiconductor device of Comparative Example. As shown in FIG. 16, the semiconductor device of Comparative Example does not have, in the drain insulating region STId, a slit from which the active region AA is exposed and further, it does not have an opening portion OA in the gate electrode GE.

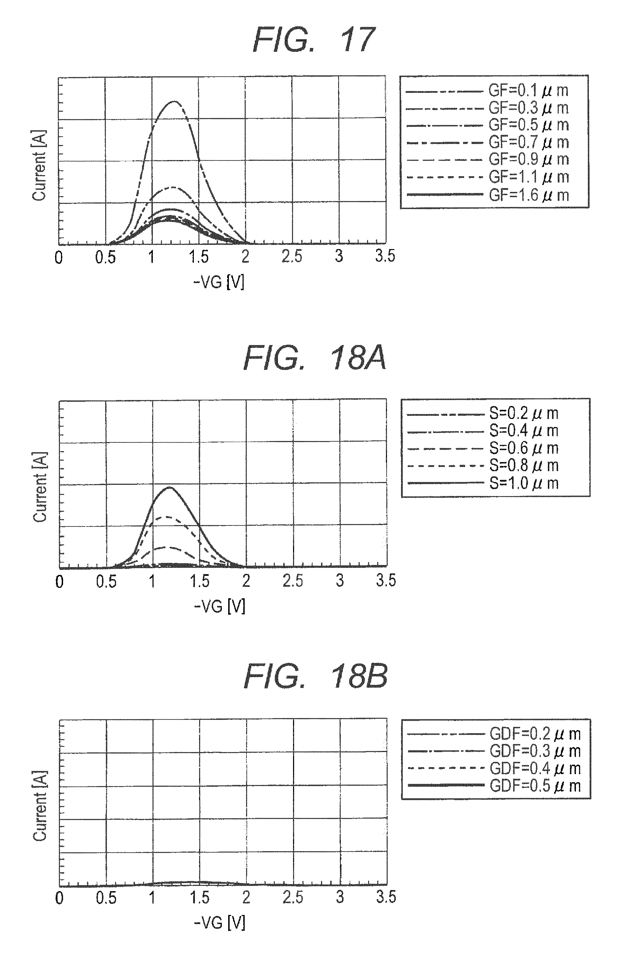

FIG. 17 is a graph showing an IG-VGS waveform of the semiconductor device of Comparative Example. A gate current (IG, Current [A]) is plotted along the ordinate and a gate-source potential (VGS, -VG [V]) is plotted along the abscissa. The IG-VGS waveform depending on the length of a distance GF at a drain voltage (VD) of -15V was studied. The distance GF is between the end portion of the drain insulating region STId on the side of the source region SR and the end portion of the gate electrode GE on the side of the drain region DR (refer to FIG. 16). The distance GF was changed from 0.1 µm to 1.6 µm. The graph shown in FIG. 17 reveals that the gate current (IG) decreases with an increase in the distance GF. In the configuration of Comparative Example, the electric field of the drain insulating region STId on the side of the channel formation region (on the side of the source region SR) can be relaxed by increasing the distance GF.

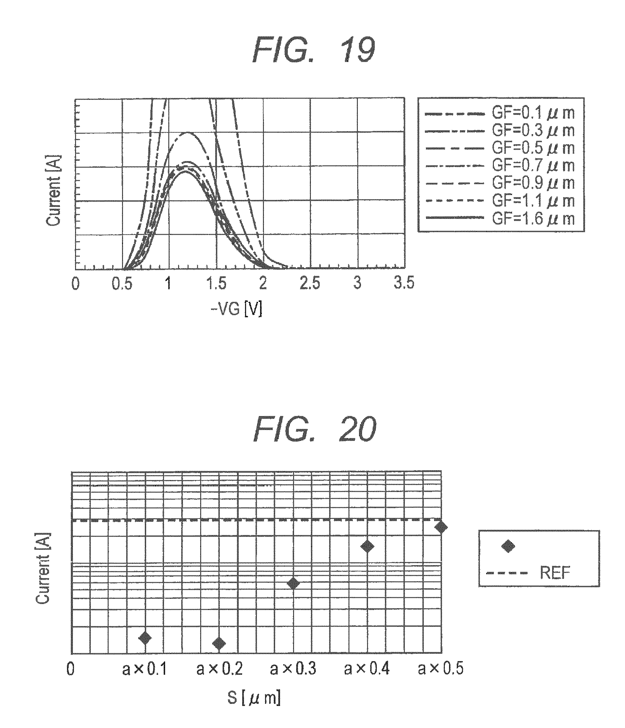

FIG. 18 is a graph showing an IG-VGS waveform of the semiconductor device of the present embodiment. A gate current (IG, Current [A]) is plotted along the ordinate and a gate-source potential (VGS, -VG [V]) is plotted along the abscissa. The IG-VGS waveform depending on a distance GFD and a distance S at a drain voltage (VD) of -15V was studied. A graph when the distance S is changed is shown in FIG. 18A, while a graph when the distance GFD is changed is shown in 18B. FIG. 19 is a graph obtained by enlarging the graph of Comparative Example shown in FIG. 17. The graph of Comparative Example shown in FIG. 17 is enlarged in order to make the scale of its ordinate correspond to that of FIGS. 18A and 18B. The distance GFD is between the end portion of the second insulating portion STId2 on the side of the drain region DR and the end portion of the gate electrode portion GE2 on the side of the drain region DR (refer to FIG. 1). The distance S is between the end portion of the first insulating portion STId1 on the side of the source region SR and the end portion of it on the side of the drain region DR (refer to FIG. 1). The distance S is set at 0.2 µm in FIG. 18B.

As shown in FIG. 18A, the gate current (IG) decreases with a decrease of the distance S from 1.0 µm to 0.2 µm. As shown in FIG. 18B, the gate current (IG) shows almost no change even when the distance S is set at 0.2 µm and the distance GFD is decreased from 0.2 µm to 0.5 µm. The gate current (IG) shown in FIGS. 18A and 18B is much smaller than the gate current (IG) of Comparative Example shown in FIG. 19.

It has been revealed that the semiconductor device of the present embodiment can have a reduced gate current (IG) and therefore have improved HCI-related properties. It has also been revealed that the effect is larger when the distance S is smaller, while the distance GFD has a slight influence.

FIG. 20 is a graph showing the relationship between the gate current and the distance S in the semiconductor device of the present embodiment. The maximum value (IG-max, Current [A]) of the gate current is plotted along the ordinate and the distance S [µm] is plotted along the abscissa. In this graph, REF means IG-max of the semiconductor device of Comparative Example having a distance GF of 1.6 µm and a of the abscissa is a sum of the respective X-direction widths of the first insulating portion STId1 and the second insulating portion STId2. For example, when the sum of the X-direction width of the first insulating portion STId1 and that of the second insulating portion STId2 is 2 µm, a×0.1 is equal to 0.2 µm.

It has been revealed from FIG. 20 that the gate current (IG) becomes smaller with a decrease in the distance S. It has also been revealed that the gate current (IG) decreases with a decrease in the X-direction width of the first insulating portion STId1 with respect to the sum of the X-direction width of the first insulating portion STId1 and that of the second insulating portion STId2. There is almost no difference in the gate current (IG) between a×0.1 and a×0.2. It has been revealed further that the gate current (IG) becomes smaller than that of the semiconductor device of Comparative Example by setting the distance S at a×0.5 or less.

Thus, it has been revealed that the semiconductor device of the present embodiment can have a reduced gate current (IG) and therefore have improved HCI-related properties.

Next, the effect for improving the HCI-related properties is verified based on simulation results.

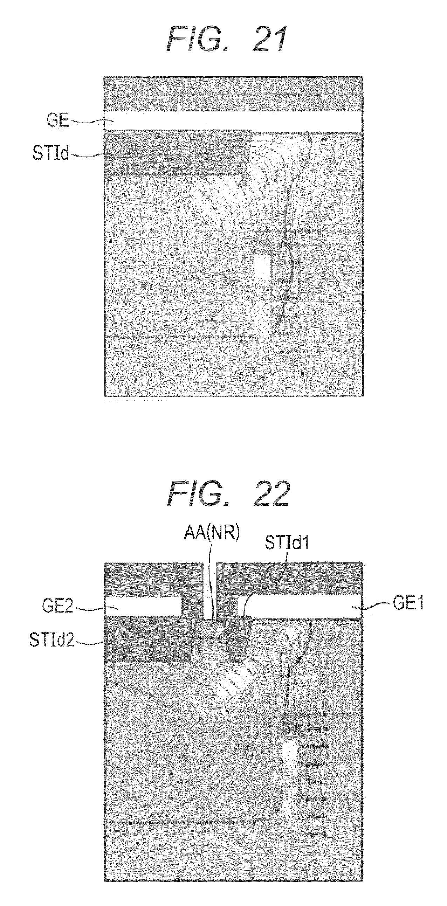

FIG. 21 shows the potential distribution and impact ionization position of the semiconductor device of Comparative Example. FIG. 22 shows the potential distribution and impact ionization position of the semiconductor device of the present embodiment. The potential distribution is indicated by isoelectric lines and the impact ionization is indicated by gray shading. In the semiconductor device of the present embodiment, the distance S was set at 0.2 µm and the width of the active region AA was set at 0.2 µm. The drain voltage was set equal to that of Comparative Example.

As shown in FIG. 21, in the semiconductor device of Comparative Example, the density of isoelectric lines is high in the vicinity of the corner portion of the drain insulating region STId, showing occurrence of impact ionization. As shown in FIG. 22, in the semiconductor device of the present embodiment, the density of isoelectric lines is low in the vicinity of the corner portion of the drain insulating region STId, showing difficulty in causing impact ionization.

FIG. 23 shows the potential distribution and electron current density of the semiconductor device of Comparative Example. FIG. 24 shows the potential distribution and electron current density of the semiconductor device of the present embodiment. The potential distribution is indicated by isoelectric lines and the electron current density is indicated by gray shading.

As is apparent from FIG. 23, in the semiconductor device of Comparative Example, density of isoelectric lines and electron current density become high in the vicinity of the corner portion of the drain insulating region STId. As is apparent from FIG. 24, in the semiconductor device of the present embodiment, density of isoelectric lines becomes low and electron current density becomes low in the vicinity of the corner portion of the drain insulating region STId. In addition, in the semiconductor device of the present embodiment, a region having a high electron current density spreads to the vicinity of the active region AA, that is, the n type semiconductor region (NR). This suggests that an electron current is partially extracted by the active region AA, that is, the n type semiconductor region (NR). In other words, this region is effective for extracting hot electrons generated at the time of HCI.

Thus, as can also been supported by the above simulation results, the semiconductor device of the present embodiment can have improved HCI-related properties.

### (Second Embodiment)

In First Embodiment (FIG. 1), the n type semiconductor region (NR) with a relatively small depth (for example, a depth almost equal to that of the n⁺ type body contact region BC) is formed in the entire surface of the active region AA, but (1) the n type semiconductor region (NR) may be formed in a portion of the active region AA; or (2) the n type semiconductor region (NR) with a relatively large depth (for example, deeper than the n⁺ type body contact region BC) may be formed. Such configurations will hereinafter be described as Application Examples 1 and 2. It is to be noted that a difference of these examples from First Embodiment is only the shape of the n type semiconductor region (NR) to be formed in the active region AA so that only it will be described specifically.

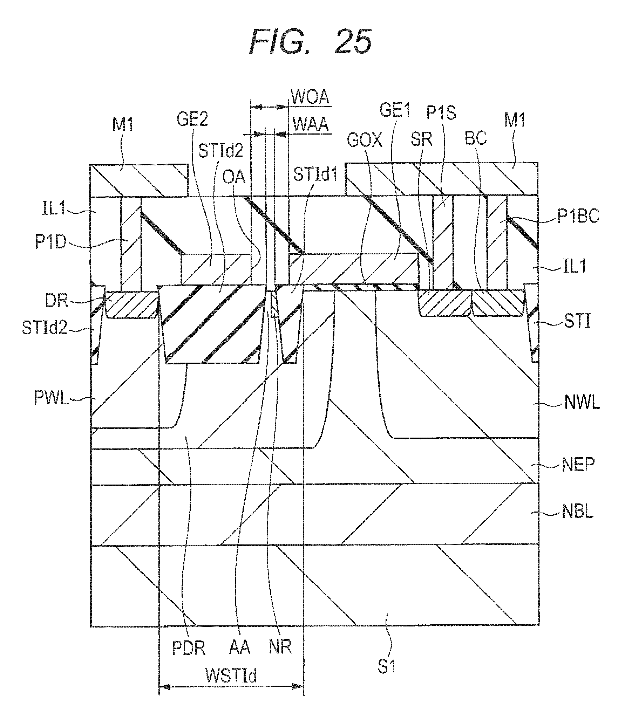

FIG. 25 is a cross-sectional view showing the configuration of a semiconductor device of Application Example 1 of the present embodiment. Members similar to those of First Embodiment (FIG. 1) will be identified by the same signs and an overlapping description will be omitted.

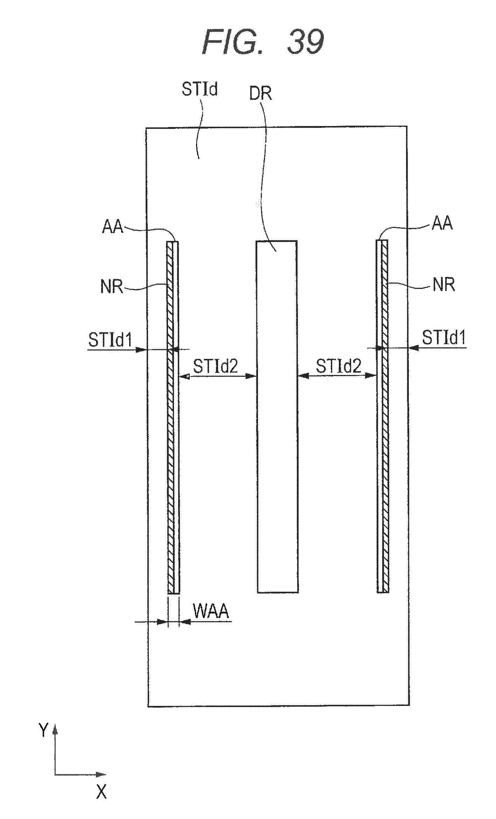

As shown in FIG. 25, the active region AA of the present application example partially has an n type semiconductor region NR. In this example, the n type semiconductor region NR is formed by introducing an n type impurity into a region having a width half of the width of the active region AA. The region having a width half of the width of the active region is a region on the side of the source region SR. As described above, the active region AA has, for example, a rectangular planar shape having a long side in the direction Y. In this case, the n type semiconductor region NR of the present Application Example has a rectangular shape having a long side in the Y direction and its X-direction width becomes half (half of WAA) of the X-direction width of the active region AA (refer to FIG. 39).

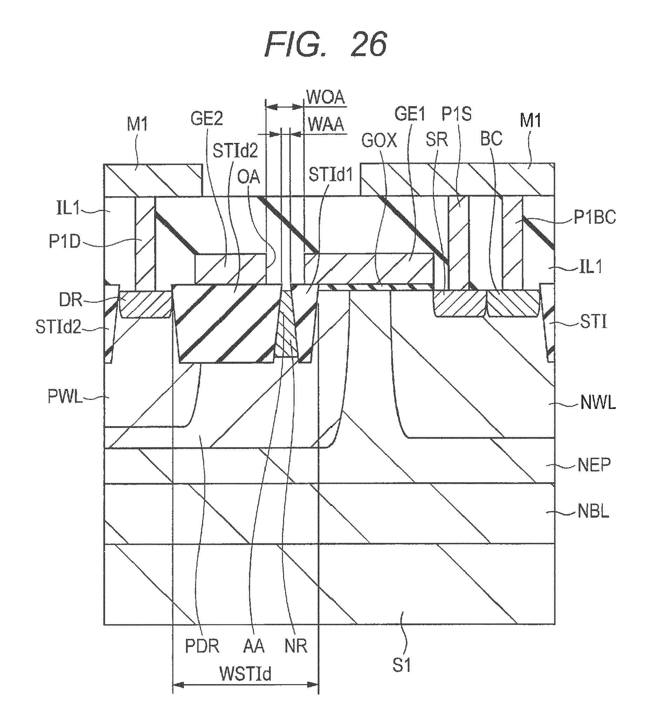

FIG. 26 is a cross-sectional view showing the configuration of a semiconductor device of Application Example 2 of the present embodiment. Members similar to those of First Embodiment (FIG. 1) will be identified by the same signs and an overlapping description will be omitted.

As shown in FIG. 26, in the present Application Example, an n type semiconductor region NR is formed by introducing an n type impurity into the active region AA so as to reach a relatively deep part thereof. For example, the depth of the n type semiconductor region NR of the present Application Example is greater than that of the n⁺ type body contact region BC and smaller than that of the first insulating portion STId1 or the second insulating portion STId2. The X-direction width of the n type semiconductor region NR of the present Application Example is almost equal to the X-direction width of the active region AA. In the present Application Example, an n type impurity is introduced into the active region AA so as to reach a relatively deep part thereof so that the impurity concentration of the n type semiconductor region NR can be reduced to a relatively low concentration. For example, the impurity concentration of the n type semiconductor region NR can be made lower than the concentration of the n⁺ type body contact region BC.

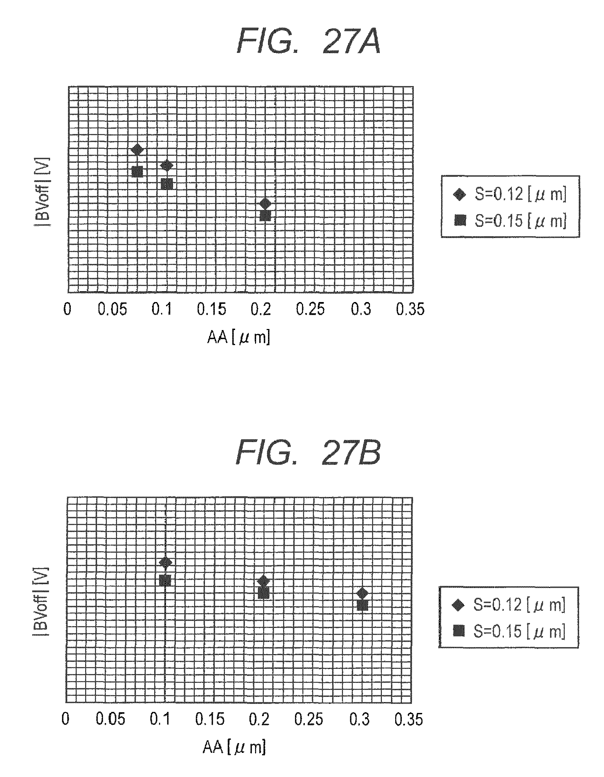

FIGS. 27A and 27B are each a graph showing the relationship between the breakdown voltage and the n type semiconductor region NR. FIG. 27A shows the relationship in the semiconductor device of First Embodiment (FIG. 1) and FIG. 27B shows that in the semiconductor device of Application Example 1 of the present embodiment. An absolute value (|BVoff|, [V]) of the breakdown voltage is plotted along the ordinate and the width (WAA) of the active region AA is plotted along the abscissa. In FIG. 27A, the width of the active region AA becomes the width of the n type semiconductor region NR as is. In FIG. 27B, the width of the n type semiconductor region NR is set at half of the width of the active region AA. The breakdown voltage at the distance S of 0.12 µm or 0.15 µm was investigated.

As shown in FIG. 27B, improvement in breakdown voltage has been confirmed when the n type semiconductor region NR is formed in a region half of the width of the active region AA.

Next, based on the simulation results, the breakdown voltage improvement effect will be verified.

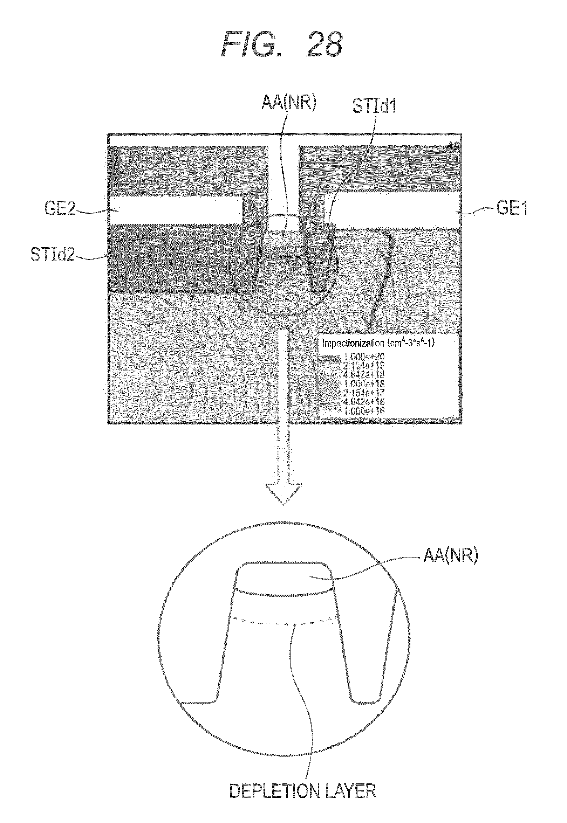

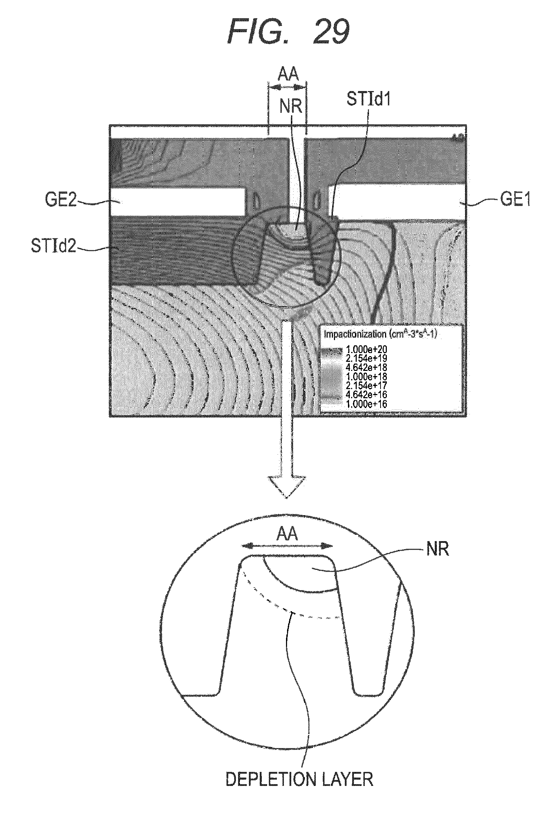

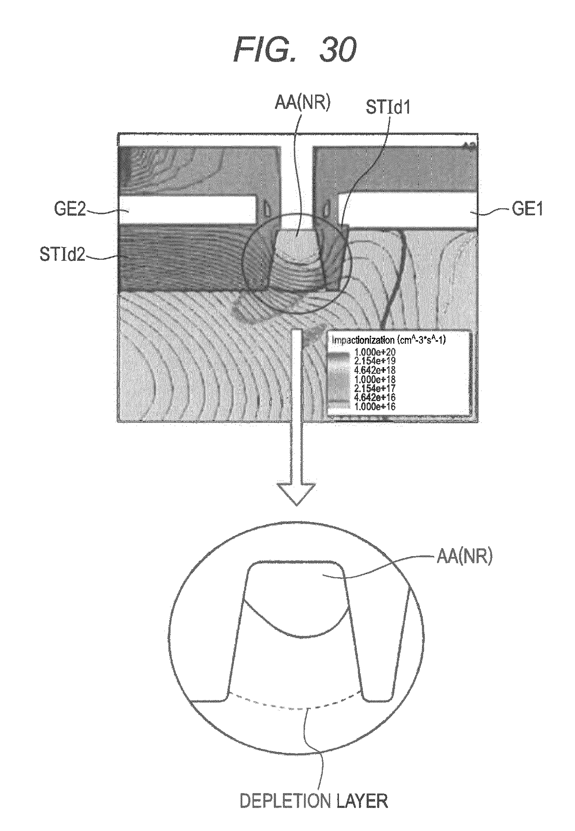

FIG. 28 shows the potential distribution and impact ionization position of the semiconductor device of First Embodiment. FIG. 29 shows the potential distribution and impact ionization position of the semiconductor device of Application Example 1 of the present embodiment. FIG. 30 shows the potential distribution and impact ionization position of the semiconductor device of Application Example 2 of the present embodiment. The potential distribution is indicated by isoelectric lines and the impact ionization is indicated by gray shading. It is to be noted that the distance S is set at 0.15 µm and the width of the active region AA is set at 0.2 µm. As the drain voltage, the same voltage is applied.

As is apparent from FIG. 28, in the semiconductor device of First Embodiment, that is, a semiconductor device having, in the entire surface of the active region AA thereof, a relatively thin n type semiconductor region NR, the density of isoelectric lines in the vicinity of the boundary between the n type semiconductor region NR and the second insulating portion STId2 becomes higher than that of Application Examples 1 and 2 of the present embodiment. This suggests that in such a structure, a relatively thin depth of the n type semiconductor region NR does not allow a depletion layer to extend and is likely to cause reduction in breakdown voltage at the time of breakdown. In FIGS. 28 to 30, extension of the depletion layer is indicated by a broken line.

As is apparent from FIG. 29, in the semiconductor device of Application Example 1 of the present embodiment, that is, a semiconductor device having, in half of the active region AA thereof, a relatively thin N type semiconductor region NR, the density of isoelectric lines between the n type semiconductor region NR and the second insulating portion STId2 becomes lower than that of First Embodiment. This suggests that in such a structure, due to presence of a region having no n type semiconductor region NR in the active region AA, the electric field is relaxed accordingly, leading to improvement in breakdown voltage.

As is apparent from FIG. 30, in the semiconductor device of Application Example 2 of the present embodiment, that is, a semiconductor device having, in the active region AA thereof, a relatively deep n type semiconductor region NR, the concentration of the n type semiconductor region NR can be reduced and therefore, the depletion layer can be extended accordingly. This leads to improvement in breakdown voltage.

Thus, it has also been confirmed based on the above-described simulation results that the semiconductor device of the present embodiment can have improved breakdown voltage.

Thus, the present embodiment has, in addition to the effect of improving HCI-related properties which has been described in detail in First Embodiment, an effect of improving breakdown voltage.

Next, a method of manufacturing the semiconductor device of Application Example 1 of the present embodiment will be described. Members other than the n type semiconductor region NR can be formed by steps similar to those of First Embodiment. The n type semiconductor region NR can be formed simultaneously with, for example, the n⁺ type body contact region BC. For formation of them, an n type impurity is ion-implanted while covering a portion (for example, a region having a width half of that of the active region AA and on the side of the drain region DR) of the active region AA with an ion implantation preventing mask.

Next, a method of manufacturing the semiconductor device of Application Example 2 of the present embodiment will be described. Members other than the n type semiconductor region NR can be formed by steps similar to those of First Embodiment. The n type semiconductor region NR can be formed, for example, by a step different from a step of forming the n⁺ type body contact region BC. For example, after formation of the n⁺ type body contact region BC by ion implantation, an n type impurity is ion-implanted while using, as a mask, an ion implantation preventing mask having an opening portion on the active region AA. Ion implantation conditions are adjusted so as to introduce the impurity into a position deeper than the n⁺ type body contact region BC at a low impurity concentration. Alternatively, the n type semiconductor region NR may be formed prior to the formation of the n⁺ type body contact region BC.

### (Third Embodiment)

In the present embodiment, an example of a planar shape of a drain region DR and an active region AA on both sides thereof will be described. In addition, an example of a planar shape of an opening portion OADR and an opening portion OA on both sides thereof will be described. The semiconductor device of Third Embodiment is similar to that of First Embodiment except for their planar shapes.

### (Application Example 1)

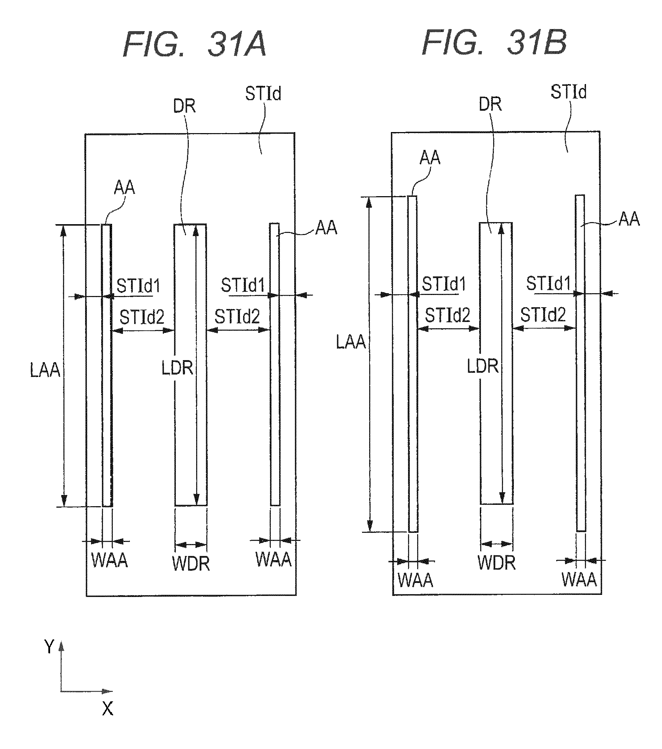

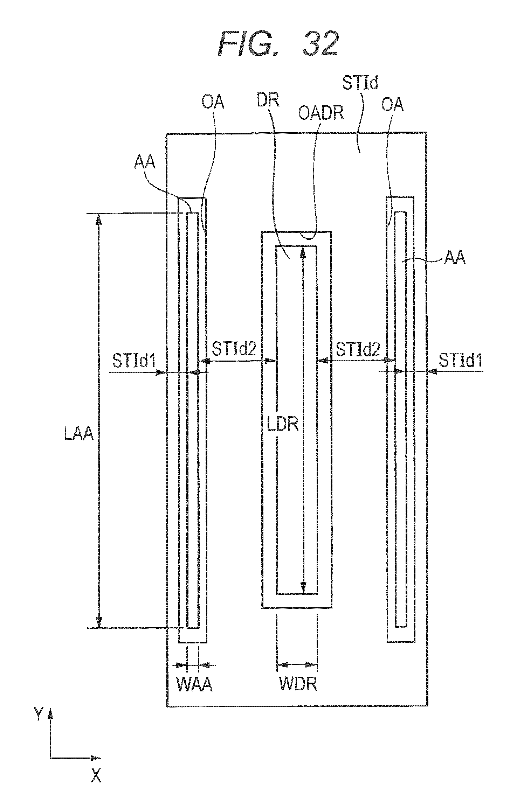

FIGS. 31A and 31B and 32 are plan views each showing the configuration of the semiconductor device of Application Example 1 of the present embodiment. In First Embodiment (FIG. 4), the active region AA is provided on both sides of the drain region DR with a predetermined distance between them. The drain region DR has a rectangular shape having a long side in the Y direction. The two active regions AA are placed symmetrically to the drain region DR and each have a rectangular shape having a long side in the Y direction. For example, in First Embodiment, as shown in FIG. 31A, the Y-direction length of the drain region DR is LDR and the Y-direction length of the active region AA is LAA. The length LDR and the length LAA are almost equal to each other. The X-direction width (X-direction length) of the drain region DR is WDR and the X-direction width (X-direction length) of the active region AA is WAA.

In Application Example, on the other hand, as shown in FIG. 31B, the Y-direction length LDR of the drain region DR is smaller than the Y-direction length LAA of the active region AA. Thus, the length LDR or length LAA may be changed.

Also in the present Application Example similar to First Embodiment, the gate electrode GE has therein an opening portion OADR and an opening portion OA on the drain region DR and the active region AA, respectively. As shown in FIG. 32, the opening portion OADR is one size greater than the drain region DR. This means that the Y-direction length of the opening portion OADR is greater than LDR and the X-direction width is greater than WDR. In addition, the opening portion OA is one size greater than the active region AA. This means that the Y-direction length of the opening portion OA is greater than LAA and the X-direction width is greater than WAA. The Y-direction length of the opening portion OA is, for example, longer than the Y-direction length of the opening portion OADR.

### (Application Example 2)

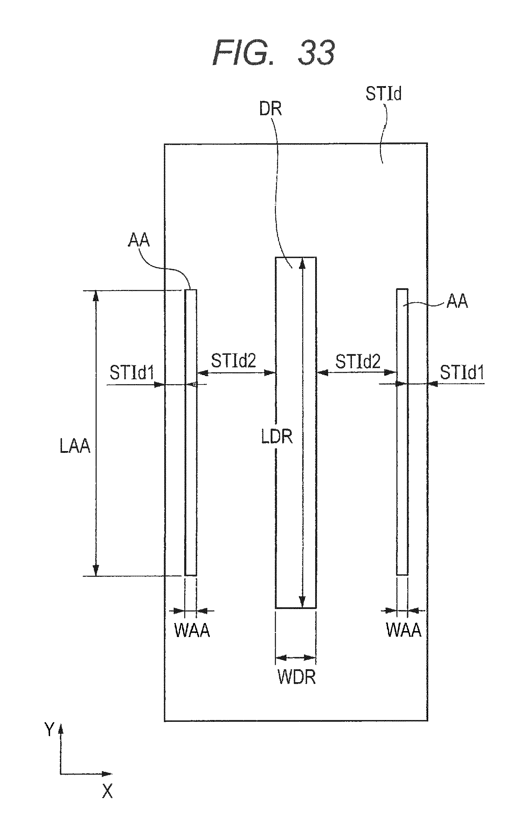

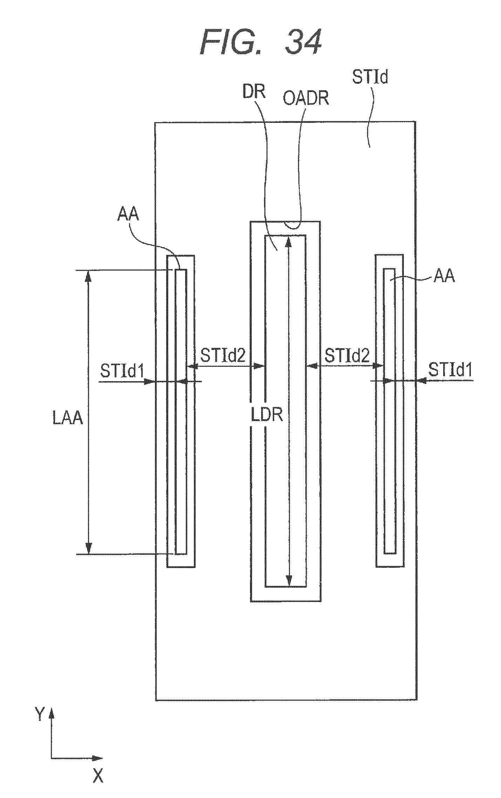

FIGS. 33 and 34 are each a plan view showing the configuration of the semiconductor device of Application Example 2 of the present embodiment.

In the present Application Example, the Y-direction length LDR of the drain region DR is greater than the Y-direction length LAA of the active region AA (FIG. 33). The length LDR or length LAA may be changed in such a manner.

In this case, the Y-direction length of the opening portion OADR is greater than LDR and its X-direction width is greater than WDR. The Y-direction length of the opening portion OA is greater than LAA and its X-direction width is greater than WAA (FIG. 34). The Y-direction length of the opening portion OA is, for example, smaller than the Y-direction length of the opening portion OADR.

### (Application Example 3)

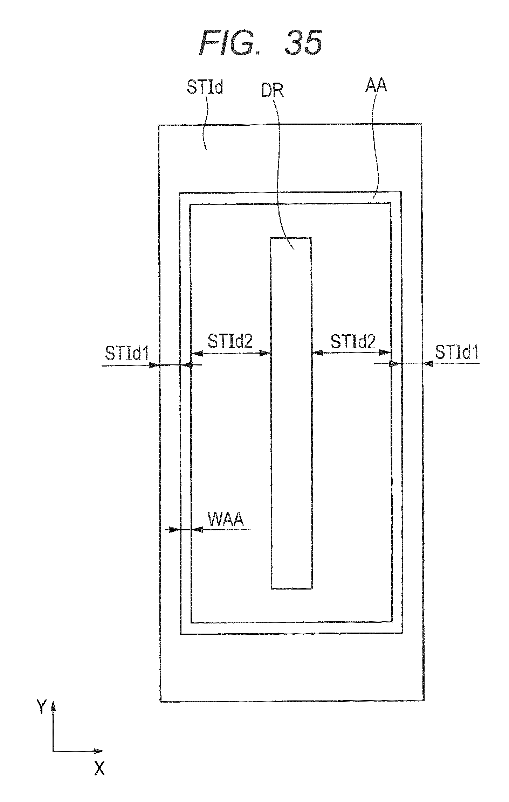

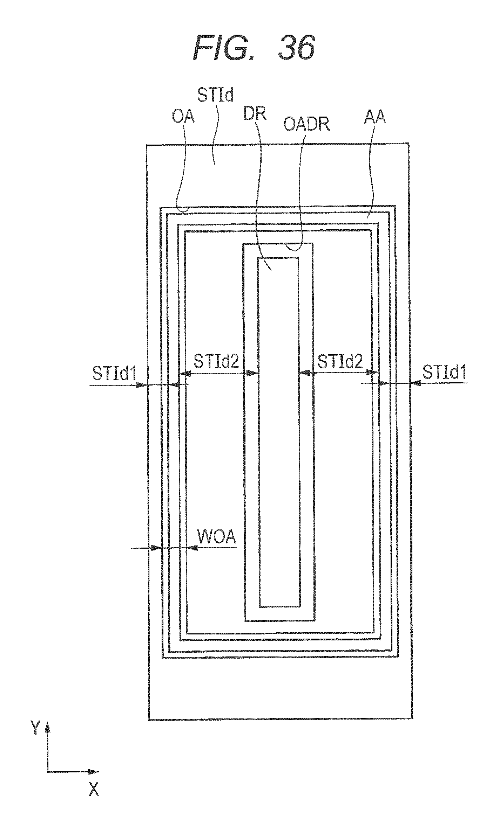

FIGS. 35 and 36 are each a plan view showing the configuration of the semiconductor device of Application Example 3 of the present embodiment.

The present Application Example has a rectangularly enclosed active region AA. In other words, the active region AA of the present Application Example has a shape corresponding to that obtained by coupling the active regions AA of Application Example 1 (refer to FIG. 31B) at the end portions thereof in the X-direction. The width of a portion of the active region AA extending in the X direction and that extending in the Y direction can be set at, for example, WAA.

In this case, also the opening portion OA on the active region AA has a rectangularly enclosed shape (FIG. 36). In other words, the opening portion OA of the present application example has a shape corresponding to that obtained by coupling the opening portions OA of Application Example 1 (FIG. 32) at the end portions thereof in the X direction. The width of a portion of the opening portion OA extending in the X direction and that extending in the Y direction can be set at, for example, WOA.

### (Application Example 4)

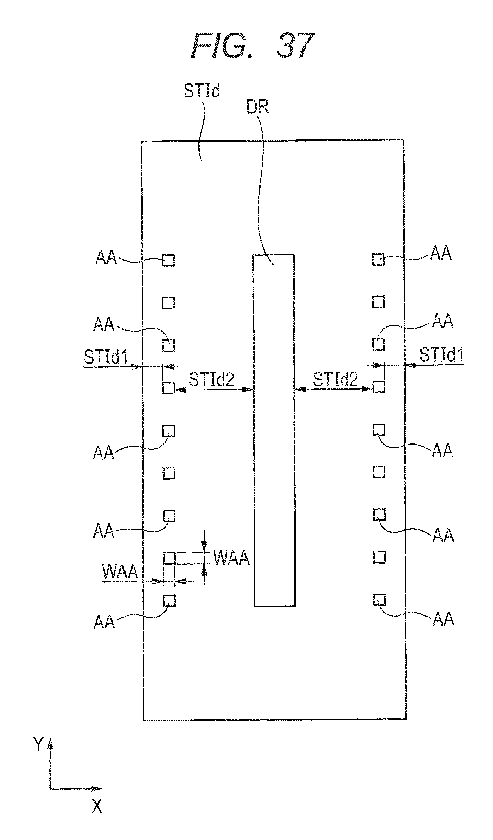

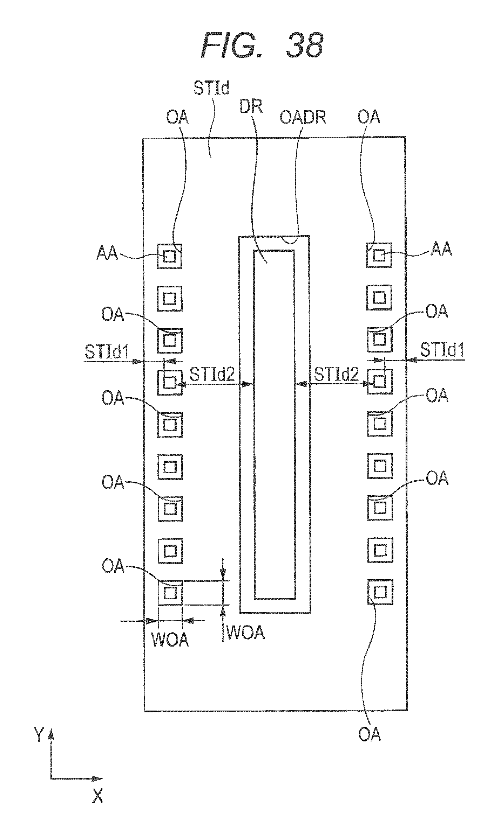

FIGS. 37 and 38 are each a plan view showing the configuration of a semiconductor device of Application Example 4 of the present embodiment.

In First Embodiment (refer to FIG. 31A), the active region AA has a rectangular shape having a long side in the Y direction. This active region AA may be divided. This means that a plurality of active regions AA with a small area may be provided. FIG. 37 shows a plurality of active regions AA, each having a square planar shape and having a side of WAA, arranged in the Y direction with a predetermined distance. Needless to say, the active regions AA may each have a rectangular shape.

In this case, as shown in FIG. 38, the opening portion OA on each of the active regions AA may be divided and arranged for each active region AA. The opening portions OA are each one size greater than the active region AA. For example, the opening portions OA may each have a square planar shape and have a side of the length WOA.

The opening portions OA may each have a rectangular shape. The opening portions OA may be provided as a contiguous opening portion on the plurality of active regions AA.

### (Application Example 5)

The n type semiconductor region (NR) in the active region AA of Application Examples 1 to 4 may be formed, as in First Embodiment, as a relatively thin region (having a depth almost equal to that of, for example, the n⁺ type body contact region BC) in the entire surface of the active region AA; or as in Application Example 1 of Second Embodiment, formed as an n type semiconductor region (NR) in a portion of the active region AA. As in Application Example 2 of Second Embodiment, the n type semiconductor region (NR) may be formed as a relatively deep region (deeper than, for example, the n⁺ type body contact region BC).

FIG. 39 is a plan view for describing a semiconductor device of Application Example 5 of Third Embodiment. FIG. 39 is a plan view showing an n type semiconductor region NR in the active region AA of Application Example 1 of Second Embodiment. In this case, the n type semiconductor region NR has a rectangular shape having a long side in the Y direction and its X-direction width is half (half of WAA) of the X-direction width of the active region AA. In the case shown in FIG. 39, the Y-direction length of the active region AA may be changed. The active regions AA and the n type semiconductor regions NR may be coupled, at the end portions thereof, in the X direction.

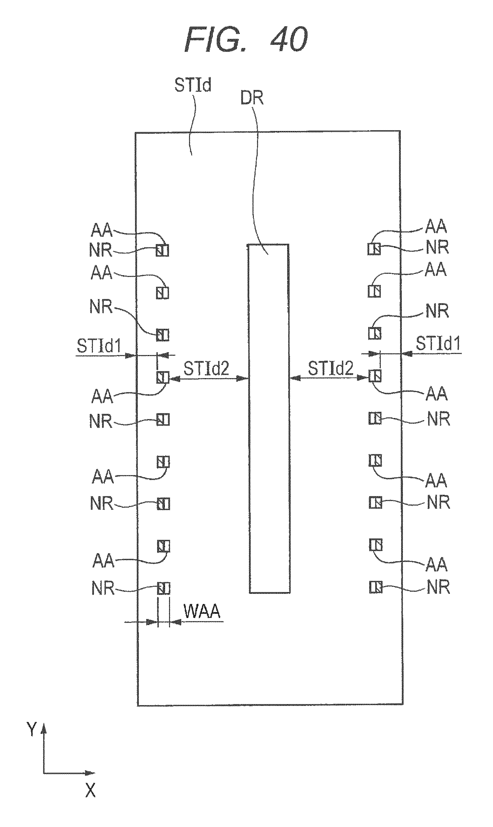

FIG. 40 is a plan view showing the configuration of the semiconductor device of Application Example 5 of the present embodiment. As shown in FIG. 40, when a plurality of active regions AA is arranged in the Y direction, the active regions AA may each have, in a portion thereof, an n type semiconductor region NR.

### (Fourth Embodiment)

In First Embodiment (in FIG. 1), a p channel type LDMOS transistor has been described as an example, but it may be replaced by an n channel type LDMOS transistor having a drain insulating region STId provided with a slit-shaped active region AA, and a gate electrode GE having an opening portion OA on this active region AA.

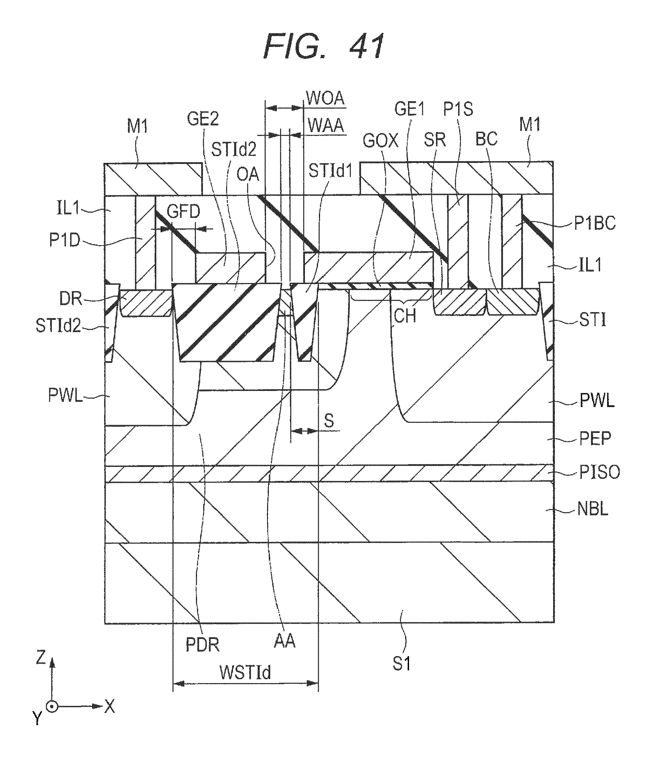

FIG. 41 is a cross-sectional view showing the configuration of the semiconductor device of the present embodiment. The semiconductor device shown in FIG. 41 has an n channel type LDMOS transistor. This semiconductor device has a configuration almost similar to that of First Embodiment except for the conductivity type of the semiconductor region so that a detailed description is omitted. Manufacturing steps are also almost similar to those of First Embodiment so that a detailed description on them is omitted.

The semiconductor regions (NEP, NWL, PDR, PWL, SR, DR, and BC) of First Embodiment (FIG. 1) correspond to semiconductor regions (PEP, PWL, NDR, NWL, SR, DR, and BC) of the present embodiment (FIG. 41), respectively. The semiconductor device of the present embodiment (FIG. 41) has a configuration almost similar to that of First Embodiment (FIG. 1) except that an impurity in the semiconductor regions has a conductivity type opposite to that of an impurity in the semiconductor regions of First Embodiment corresponding thereto. The n channel type LDMOS transistor of FIG. 41 has a first p type buried region (p type semiconductor region) PISO on the n type buried region (n type semiconductor region) NBL. The n channel type LDMOS transistor of FIG. 41 has an n well region NWL deeper than the n type drift region NDR. The n well region NWL and n type buried region NBL, as well as such a region (PISO), are unessential configuration members. Also in the p channel type LDMOS transistor, the p well region PWL and the n type buried region NBL are unessential configuration members.

The semiconductor device of the present embodiment (FIG. 41) can be formed by steps almost similar to those of First Embodiment (FIG. 1). The first p type buried region PISO can be formed by performing, after the step of forming an n type buried region NBL, ion implantation using an ion implantation preventing mask having a predetermined shape

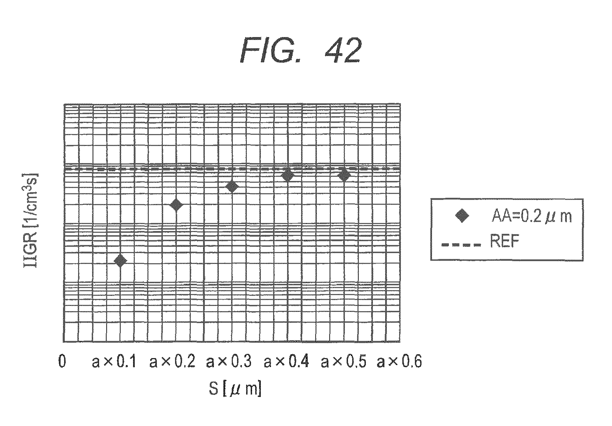

FIG. 42 is a graph showing the relationship between the gate current and the distance S of the semiconductor device of the present embodiment. In this graph, IIGR [1/cm³S] at the lower end of the drain insulating region STId on the side of the channel formation region CH (on the side of the source region SR) is plotted along the ordinate and the above-described distance S [µm] is plotted along the abscissa. It is to be noted that IIGR is an abbreviation of impact ionization generation rate. IIGR has a close relation with HCI deterioration and deterioration due to HCI is larger with an increase in IIGR. The distance S is between the end portion of the first insulating portion STId1 on the side of the source region SR and that on the side of the drain region DR (refer to FIG. 41). In the drawing, REF means IIGR of a semiconductor device of Comparative Example having the distance GF of 1.6 µm. The semiconductor device of Comparative Example is an n type LDMOS transistor having a drain insulating region STId not provided with the slit exposing therefrom the active region AA and having a gate electrode GE not provided with the opening portion OA. The "a" of the abscissa is a sum of the respective X-direction widths of the first insulating portion STId1 and the second insulating portion STId2. For example, when the sum of the respective X-direction width of the first insulating portion STId1 and the second insulating portion STId2 is 2 µm, a×0.1 is equal to 0.2 µm.

It has been revealed in FIG. 42 that with a decrease in the distance S, the IIGR decreases. It has also been revealed that with a decrease in the X-direction width of the first insulating portion STId1 with respect to the sum of the respective X-direction widths of the first insulating portion STId1 and the second insulating portion STId2, the IIGR decreases. It has further been revealed that the IIGR becomes lower than that of the semiconductor device of Comparative Example by setting the distance S at a×0.5 or less.

Thus, it has been revealed that the semiconductor device of the present embodiment can have a reduced IIGR and therefore have improved HCI-related properties.

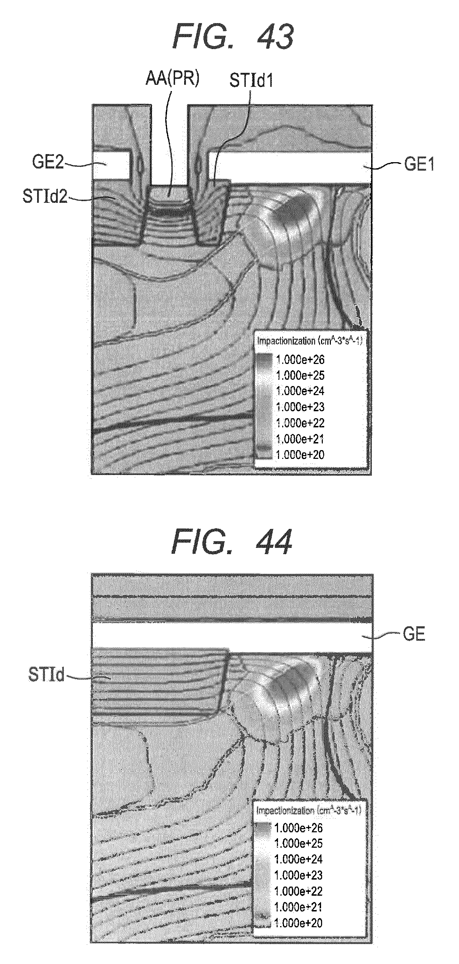

Next, based on the simulation results, the effect of improving HCI-related properties will be verified. FIG. 43 shows the potential distribution and impact ionization position of the semiconductor device of the present embodiment. FIG. 44 shows the potential distribution and impact ionization position of the semiconductor device of Comparative Example of Fourth Embodiment. As is apparent from FIG. 43, the semiconductor device of the present embodiment is unlikely to cause impact ionization because the density of isoelectric lines is low in the vicinity of the corner portion of the drain insulating region STId. On the other hand, as FIG. 44 shows, the semiconductor device of Comparative Example causes impact ionization because the density of isoelectric lines is high in the vicinity of the corner portion of the drain insulating region STId.

Thus, improvement in HCI-related properties is confirmed also by the above-described simulation results.

In the case of the n channel type LDMOS transistor, even when the potential of the p type semiconductor region (impurity region, PR) of the active region AA is made equal to that of the source region SR and the n⁺ type body contact region BC, hot electrons generated at the time of HCI cannot be extracted. A hole current generated by impact ionization can, however, be monitored by making the potential of the p type semiconductor region (PR) of the active region AA equal to that of the source region SR and the n⁺ type body contact region BC.

The hole current of the n channel type LDMOS transistor is monitored, for example, by a terminal to be coupled to a back gate such as the n⁺ type body contact region BC. This hole current is involved in hot carrier deterioration and is generated at the end portion of the drain insulating region STId on the side of the channel formation region CH (on the side of the source region SR). For example, it is particularly effective when main impact ionization occurs at a position separated from the drain insulating region at the time of HCI. As shown in FIG. 44, however, impact ionization occurs at the end portion of the drain insulating region STId so that in Comparative Example, a hole current not involved in HCI deterioration and generated by impact ionization is monitored.

As shown in FIG. 43, therefore, a hole current involved in HCI deterioration and generated by impact ionization can be monitored properly by making the potential of the p type semiconductor region (PR) of the active region AA equal to that of the source region SR and the n⁻ type body contact region BC and using it as a monitor terminal. When it is not used as a monitor, the p type semiconductor region (PR) of the active region AA may be put into, for example, a floating state.

The inventions made by the present inventors have been described specifically based on embodiments. It is needless to say that the present invention is, however, not limited to or by these embodiments but can be changed in various ways without departing from the gist of the invention.

## Claims

1. A semiconductor device, comprising:
a semiconductor layer;
a source region and a drain region formed in the semiconductor layer, while being separated from each other;
a channel formation region located between the source region and the drain region;
an insulating region formed in the semiconductor layer between the channel formation region and the drain region; and
a gate electrode formed over the channel formation region via a gate insulating film and extending to above the insulating region,
wherein the insulating region has a slit exposing therefrom an active region, and
wherein the slit is placed on the side of the channel formation region with respect to a center of the insulating region.

2. The semiconductor device according to Claim 1,
wherein the active region exposed from the slit has therein an impurity region having a conductivity type opposite to that of the source region and the drain region.

3. The semiconductor device according to Claim 1 or 2,
wherein the gate electrode has an opening over the slit.

4. The semiconductor device according to Claim 3,
wherein the slit and the opening portion extend in a first direction, and
wherein a width of the opening portion in a second direction intersecting the first direction is greater than a width of the slit in the second direction.

5. The semiconductor device according to Claim 3 or 4,
wherein a length of the opening portion in the first direction is greater than a length of the slit in the first direction.

6. The semiconductor device according to Claim 3, 4 or 5,
wherein the gate electrode surrounds the slit therewith.

7. The semiconductor device according to one of Claims 2 to 6,
wherein the impurity region is electrically coupled to the source region.

8. The semiconductor device according to one of Claims 2 to 7,
wherein the active region exposed from the slit has therein the impurity region.

9. The semiconductor device according to one of Claims 2 to 8,
wherein the impurity region is placed on the side of the channel formation region.

10. The semiconductor device according to Claim 9, wherein the slit and the impurity region extend in the first direction, and
wherein a width of the impurity region in a second direction intersecting the first direction is smaller than a width of the slit in the second direction.

11. The semiconductor device according to one of Claims 2 to 10, further comprising:
a back gate region adjacent to the source region,
wherein the back gate region has a conductivity type opposite to that of the source region and the drain region.

12. The semiconductor device according to one of Claims 2 to 11,
wherein a depth of the impurity region is greater than a depth of the source region or the drain region.

13. The semiconductor device according to one of claims 1 to 12, wherein Said insulating reagion instead of a slit has therein a plurality of regions exposing therefrom an active region, and
wherein the plurality of regions is arranged on the side of the channel formation region with respect to the center of the insulating region, while having a space between or among them in a first direction.

14. A method of manufacturing a semiconductor device, comprising the steps of:
(a) forming an insulating region in a semiconductor layer between a source formation region and a drain formation region and on the side of the drain formation region;
(b) forming a gate electrode, via a gate insulating film, over the semiconductor layer between the insulating region and the source formation region; and
(c) introducing an impurity having a first conductivity type into the semiconductor layer of the source formation region and that of the drain formation region to form a source region and a drain region, respectively,
wherein in the step (a), a slit exposing therefrom an active region is formed in the insulating region on the side of the channel formation region with respect to the center of the insulating region, and
wherein in the step (b), the gate electrode extends to above the insulating region.

15. The method of manufacturing a semiconductor device according to Claim 14, further comprising the step of:
(d) introducing an impurity having a second conductivity type, which is a conductivity type opposite to the first conductivity type, into the active region in the insulating region to form an impurity region, or
(d) introducing an impurity having a second conductivity type, which is a conductivity type opposite to the first conductivity type, into a portion of the active region in the insulating region to form an impurity region.

16. The method of manufacturing a semiconductor device according to Claim 15,
wherein in the step (d), a back gate region is formed in a region adjacent to the source region by introducing an impurity having the second conductivity type into a region adjacent to the source region.

17. The method of manufacturing a semiconductor device according to Claim 15 or 16, further comprising the step of:
(e) introducing an impurity having the second conductivity type into a region adjacent to the source region to form a back gate region,
wherein the impurity region is deeper than the back gate region.
